(19) Europäisches Patentamt / European Patent Office / Office européen des brevets

(11) **EP 3 076 195 B1**

(12) **EUROPÄISCHE PATENTSCHRIFT**

(45) Veröffentlichungstag und Bekanntmachung des Hinweises auf die Patenterteilung:
**17.06.2020 Patentblatt 2020/25**

(51) Int Cl.:
***G01R 31/14*** *(2006.01)*

(21) Anmeldenummer: **16154756.7**

(22) Anmeldetag: **09.02.2016**

(54) **SCHALTUNGSANORDNUNG ZUR KABELPRÜFUNG, KABELTESTUNG, KABELDIAGNOSE UND/ODER KABELFEHLERORTUNG UND GERÄT MIT EINER DERARTIGEN SCHALTUNGSANORDNUNG**

CIRCUIT ASSEMBLY FOR CABLE CHECKING, CABLE TESTING, CABLE DIAGNOSIS AND/OR THE LOCALIZATION OF FAULTS IN CABLES, AND AN INSTRUMENT INCORPORATING SUCH A CIRCUIT ASSEMBLY

SYSTEME DE CIRCUIT POUR VERIFICATION DE CABLE, ESSAI DE CABLE, DIAGNOSTIC DE CABLE ET/OU LOCALISATION DE DEFAUT ET APPAREIL COMPRENANT UN TEL SYSTEME DE CIRCUIT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.02.2015 DE 102015202597**

(43) Veröffentlichungstag der Anmeldung:
**05.10.2016 Patentblatt 2016/40**

(73) Patentinhaber: **Hagenuk KMT Kabelmesstechnik GmbH**
**01471 Radeburg (DE)**

(72) Erfinder: **Stechemesser, Nico**
**01067 Dresden (DE)**

(74) Vertreter: **Kailuweit & Uhlemann Patentanwälte Partnerschaft mbB**
**Bamberger Straße 49**
**01187 Dresden (DE)**

(56) Entgegenhaltungen:
**WO-A1-2013/120539     DE-A1- 3 805 733**
**DE-A1- 19 513 441     DE-B3-102012 024 560**

**Beschreibung**

Die Erfindung betrifft Schaltungsanordnungen zur Kabelprüfung, Kabeltestung, Kabeldiagnose und/oder Kabelfehlerortung in Verbindung mit einem Kabel als Prüfling mit

- einer einen ersten Spannungsvervielfacher für eine positive Spannung und einen zweiten Spannungsvervielfacher für eine negative Spannung aufweisenden Spannungsquelle
- miteinander verbundenen Stromquellen in Verbindung mit den Spannungsvervielfachern zum Erzeugen einer Prüfspannung über der Lastimpedanz des Kabels zum Aufladen und zum Entladen der Lastkapazität des Kabels, wobei die miteinander verbundenen Stromquellen über einen Schutzwiderstand mit dem Kabel und einem Spannungsteiler verbunden sind, und
- einer mit der Spannungsquelle und den Stromquellen zusammengeschalteten Steuereinrichtung und

Geräte mit einer derartigen Schaltungsanordnung.

Durch die Druckschrift DE 195 13 441 A1 ist ein Verfahren zur Prüfung der Isolation elektrischer Betriebsmittel sowie Schaltungsanordnung zur Ausführung des Verfahrens bekannt. Eine derartige Schaltungsanordnung kann zur Verlustfaktormessung benutzt werden. Aus den Phasenlagen der Prüfspannung und des daraus induzierten Prüfstroms wird der Verlustfaktor (tan Delta) des Prüflings bestimmt. Der Verlustfaktor ist ein Maß für den Verlust der elektrisch oder elektromagnetisch verlorengehenden Energie und damit ein Merkmal der elektrischen Eigenschaften des Prüflings. Die Erzeugung der Wechselspannung zur Prüfung erfolgt in mehreren Schritten aus einer Netzspannung. Aus der Netzspannung wird mit Hilfe eines Gleichrichters eine Gleichspannung erzeugt. Diese wird in Wechselspannungen mit Netzfrequenz oder einem Vielfachen der Netzfrequenz umgewandelt, welche mit Wechselspannungen niederer Frequenz in ihrer Amplitude moduliert sind. Durch Transformation der Niederspannungen mittels Hochspannungstransformatoren wird eine mit sehr niederer Frequenz amplitudenmodulierte Hochspannung erzeugt, mit welcher ein Prüfling über eine Gleichrichterschaltung definiert aufgeladen wird und danach eine definierte Entladung des Prüflings über einen Hochspannungsschalter erfolgt. Durch eine Regelung wird der Verlauf der über einen Spannungsteiler gemessenen Hochspannung zeitkritisch mit der gewünschten vorprogrammierten Kurvenform und Amplitude verglichen und unter anderem auch durch Eingriff auf die Schaltzeitpunkte an Schaltelementen von H-Brücken die Einhaltung garantiert. Dieser Regelungseingriff führt zu Kanten im Verlauf der Prüfspannung, die wiederum Oberwellen und Rauschen verursachen. Damit wird die Genauigkeit des Messvorgangs negativ beeinflusst.

Die Druckschrift DE 10 2012 024 560 B3 beinhaltet eine Schaltungsanordnung und ein Verfahren zur Erzeugung einer Prüfspannung und ein Prüfgerät zur Ermittlung eines Verlustfaktors, welches die Schaltungsanordnung enthält. Die Schaltungsanordnung besteht im Wesentlichen aus zwei Hochspannungsquellen zur Erzeugung einer positiven und einer negativen Hochspannung variabler Amplitude und eine zwischen den Ausgängen der Hochspannungsquellen und dem Prüfling angeordneten Hochspannungsschalteranordnung zur sukzessiven Auf- und Entladung des Prüflings. Mittels einer Regelung wird die aktuelle Prüfspannung am Prüfling gemessen und in Abhängigkeit davon wirkt diese zur definierten Auf-und Entladung des Prüflings auf die Hochspannungsschalteranordnung ein. Die Regelung wirkt nicht auf die Hochspannungsquellen ein. Eine separate mit den Hochspannungsquellen verbundene Steuerung erzeugt ein unabhängiges Taktsignal, so dass von den Hochspannungsquellen eine synchronisierte, vordefinierte und nicht durch die Regelung beeinflusste Hochspannung bereitgestellt wird. Die Hochspannungsquellen stellen eine anhand des Taktsignals synchronisierte und in ihrer Kurvenform und Phasenlage exakt vordefinierte Hochspannung variabler Amplitude bereit.

Die Hochspannungsschalteranordnung umfasst zwei Halbleiterschalteranordnungen als spannungsgesteuerte Stromquellen, die über je einen Verstärker rückgekoppelt sind. Zur Funktion der Stromquellen ist eine Vorlaufspannung notwendig, durch die die Stromquellen in der Lage sind, die Ausgangsspannung zu regeln. Gleichzeitig ist man bestrebt, die Vorlaufspannung so gering wie möglich zu halten und somit die Verlustleistung zu minimieren. In diesem Zusammenhang ist darauf hinzuweisen, dass der Ausgangsstrom hautsächlich durch die Wahl der Prüfspannung und den angeschlossenen Prüfling bestimmt wird. Er kann nicht durch eine geeignete Ausgestaltung des Hochspannungsprüfgeräts beeinflusst werden. Zur Regelung der Stromquellen ist damit eine gegenüber der Lösung in der Druckschrift DE 195 13 441 A1 größere Vorlaufspannung notwendig.

Die Druckschrift DE 10 2013 008 611 A1 beinhaltet ein Hochleistungs-Hochspannungsprüfgerät, wobei die Mittel zur Erzeugung der Prüfspannung wenigstens zwei Spannungsverstärkerzweige aufweisen, von denen ein erster Spannungsverstärkerzweig zur Erzeugung der positiven Spannungshalbwellen der Prüfspannung und ein zweiter Spannungsverstärkerzweig zur Erzeugung der negativen Spannungshalbwellen der Prüfspannung dient. Weiterhin ist eine Messschaltung zur Messung der an einem Messobjekt anzulegenden Prüfspannung und des hierdurch im Messobjekt verursachten Prüfstroms vorhanden. Das Prüfgerät zeichnet sich dadurch aus, dass jeder Spannungsverstärkerzweig in einer separaten Baugruppe mit integrierter aktiver Luftkühlung verbaut ist.

Darüber hinaus ist aus der Druckschrift Kearley, S.J.; MacKinlay, R. R.: Discharge measurements in cables using a solid state 30 kV bipolar low frequency generator. In: Dielectric Materials, Measurements and Applications, 1988., Fifth International Conference on, 1988, 171-174, eine Schaltungsanordnung auch für eine Spannungsamplitude von wenigstens 100 kV bekannt. Mittels einer als steuerbare Stromquelle fungierenden Halbleiterschalteranordnung wird eine in ihrem Verlauf regelbare Prüfspannung zur definierten Auf- und Entladung eines Messobjekts erzeugt, wobei unter Auswertung des am Messobjekt gemessenen Prüfstroms und/oder der Prüfspannung die durch die vorgeschalteten Komponenten des Spannungsverstärkerzweigs erzeugte positive oder negative Hochspannung in positive oder negative Spannungshalbwellen gewandelt werden.

Der in den Patentansprüchen 1 und 14 angegebenen Erfindung liegt die Aufgabe zugrunde, beliebige Spannungsformen unterschiedlicher Amplitude über einem Kabel als Impedanz als Prüfling zu erzeugen.

Diese Aufgabe wird mit den in den Patentansprüchen 1 und 14 aufgeführten Merkmalen gelöst.

Die Schaltungsanordnungen zur Kabelprüfung, Kabeltestung, Kabeldiagnose und/oder Kabelfehlerortung in Verbindung mit einem Kabel als Prüfling mit

- einer einen ersten Spannungsvervielfacher für eine positive Spannung und einen zweiten Spannungsvervielfacher für eine negative Spannung aufweisenden Spannungsquelle
- miteinander verbundenen Stromquellen in Verbindung mit den Spannungsvervielfachern zum Erzeugen einer Prüfspannung über der Lastimpedanz des Kabels zum Aufladen und zum Entladen der Lastkapazität des Kabels, wobei die miteinander verbundenen Stromquellen über einen Schutzwiderstand mit dem Kabel und einem Spannungsteiler verbunden sind, und
- einer mit der Spannungsquelle und den Stromquellen zusammengeschalteten Steuereinrichtung,

zeichnen sich insbesondere dadurch aus, dass beliebige Spannungsformen unterschiedlicher Amplitude über dem Kabel als eine Impedanz als Prüfling erzeugbar sind.

Dazu weist die Steuereinrichtung einen digitalen Signalprozessor zur Regelung der über den Spannungsteiler gemessenen Prüfspannung über der Lastimpedanz des Kabels und zur Sollwertvorgabe der Spannungsquelle auf. Die Spannungsvervielfacher sind entweder mit zwei Hauptwandlern oder sowohl einem Hauptwandler als auch einem eine positive und eine negative Hilfsspannung erzeugenden Hilfswandler so verbunden, dass an den Ausgängen der Spannungsvervielfacher entweder eine entsprechend der Sollwertvorgabe positive Spannung und eine konstante ungesteuerte negative Spannung oder eine entsprechend der Sollwertvorgabe negative Spannung und eine konstante ungesteuerte positive Spannung anliegen. Dabei wird die jeweilig ungesteuerte Spannung entweder durch den jeweiligen Hauptwandler oder durch den ungesteuerten Hilfswandler erzeugt. Die Spannungsvervielfacher sind über jeweils eine Koppeldiode mit den Stromquellen zusammengeschaltet, so dass das Rückwärtsspeisen der Spannungsvervielfacher verhindert ist. Die miteinander verbundenen Stromquellen sind über wenigstens einen Schutzwiderstand mit dem Spannungsteiler und dem Kabel verbunden. Darüber hinaus sind die beiden miteinander verbundenen Bezugspotentiale der Spannungsvervielfacher über eine an den Messbereich anpassbare Messimpedanz mit dem Bezugspotential des Kabels verbunden, wobei die Bezugspotentiale der Spannungsvervielfacher und das Bezugspotential des Spannungsteilers eine Hilfserde sind.

Mittels der Schaltungsanordnung können vorteilhafterweise beliebige Spannungsformen über einer Impedanz erzeugt werden. Das erfolgt mittels der einen digitalen Signalprozessor enthaltenden Steuereinrichtung. Weiterhin kann eine hochpräzise Messung des Stromes durch diese Impedanz erfolgen. Die Schaltungsanordnung stellt damit einen arbiträren Funktionsgenerator für Spannungen dar, der gleichzeitig ein hochpräzises Messinstrument für ohmsche, kapazitive und ohmsch-kapazitive Lasten insbesondere zur Verlustfaktorbestimmung ist.

In einer ersten Variante enthält die Schaltungsanordnung eine Spannungsquelle mit einem Hilfswandler, der eine ungesteuerte positive und negative Gleichspannung fester Amplitude erzeugt. Weiterhin ist ein Hauptwandler vorhanden, der an den jeweiligen Spannungsvervielfacher geschalten werden kann. Damit kann am positivem Spannungsvervielfacher eine positive Spannung variabler Amplitude erzeugt werden, während gleichzeitig am negativem Spannungsvervielfacher die ungesteuerte negative Spannung des Hilfswandlers anliegt. Weiterhin kann am negativem Spannungsvervielfacher eine negative Spannung variabler Amplitude erzeugt werden, während gleichzeitig am positivem Spannungsvervielfacher die ungesteuerte positive Spannung des Hilfswandlers anliegt.

In einer zweiten Variante enthält die Schaltungsanordnung eine Spannungsquelle mit Hauptwandlern, die an die Spannungsvervielfacher geschalten sind. Damit kann am positivem Spannungsvervielfacher eine positive Spannung variabler Amplitude erzeugt werden, während gleichzeitig am negativem Spannungsvervielfacher eine ungesteuerte negative Spannung des anderen Hauptwandlers anliegt. Weiterhin kann am negativem Spannungsvervielfacher eine negative Spannung variabler Amplitude erzeugt werden, während gleichzeitig am positivem Spannungsvervielfacher eine ungesteuerte positive Spannung des anderen Hauptwandlers anliegt. Damit wird durch den jeweilig anderen Hauptwandler eine ungesteuerte positive und negative Gleichspannung fester Amplitude erzeugt.

Bei beiden Varianten kann damit die Spannung über den Stromquellen nicht kleiner als die jeweilige Gleichspannung fester Amplitude werden. Mit Hilfe der Stromquellen wird die Ausgangsspannung geregelt und damit das Kabel beaufschlagt. Die Stromquellen werden mit Hilfe einer Pulsweitenmodulation angesteuert. Es sind Stromquellen mit spannungsgesteuerten Transistoren. Insbesondere können potentialfreie spannungsgesteuerte Stromquellen eingesetzt werden.

Die Spannung über dem Kabel als Prüfling folgt der Vorgabe aus dem digitalen Signalprozessor der Steuereinrichtung als Referenz. Dazu ist die Steuereinrichtung weiterhin eine von dem Spannungsteiler Messwerte erfassende Steuereinrichtung, die weiterhin die Spannungsquelle und die Stromquellen entsprechend der Vorgabe des digitalen Signalprozessors steuert/regelt. Damit ist bei positivem Vorzeichen der Referenz die Spannung am positivem Spannungsvervielfacher exakt in Phasenlage und synchron zur Spannung über dem Kabel als Prüfling. Bei negativem Vorzeichen der Referenz ist die Spannung am negativem Spannungsvervielfacher exakt in Phasenlage und synchron zur Spannung über dem Kabel als Prüfling. Der Spannungsteiler ist dazu ein Hochspannungsmessteiler.

Für eine präzise Messwerterfassung sind die beiden miteinander verbundenen Fußpunkte der Spannungsvervielfacher über die an den Messbereich anpassbare Messimpedanz an den Fußpunkt des Prüflings als Lastimpedanz verbunden. Die Fußpunkte der Hochspannungskaskaden sind damit an die Hilfserde angeschlossen. Mit der Hilfserde kann stromrichtig gemessen werden. Damit ist eine hochauflösende und genaue Verlustfaktormessung (tan delta) des Kabels möglich.

Das Gerät zur Kabelprüfung, Kabeltestung, Kabeldiagnose und/oder Kabelfehlerortung beinhaltet die Schaltungsanordnung. Die Spannungsquelle befindet sich dabei in einer abgeschirmten Umhausung, wobei die Umhausung die Hilfserde ist. Ein Anschlusskabel des Kabels ist ein abgeschirmtes Anschlusskabel, wobei die Abschirmung des Anschlusskabels mit der Hilfserde verbunden ist. Damit werden vorteilhafterweise die ansonsten zum Kabelschirm des Anschlusskabels und die zur Umhausung der Spannungsquelle fließenden Ableitströme nicht erfasst. Es erfolgt eine Messung ausschließlich des Stroms, der im Kabel als Prüfling fließt.

Mit der Schaltungsanordnung und dem Gerät sind vorteilhafterweise hochpräzise Verlustfaktormessungen als tan Delta Messungen möglich. Die Messgenauigkeit kann $1 \times 10^{-4}$ über den gesamten Spannungsbereich liegen. Dieser kann dabei jeweils einschließlich größer 1kV bis kleiner 250kV betragen.

Bei einer Kabelprüfung oder Kabeldiagnose wird das Kabel dabei beispielsweise zyklisch aufgeladen und entladen. Die beim Entladen entstehende Verlustwärme muss abgeführt werden. Damit die Regelung und die Stromquellen selbst funktionieren, kann die Spannung über den Stromquellen als Vorlaufspannung im Bereich von 300 V bis 10 kV liegen. Je niedriger dabei die Vorlaufspannung ist, um so geringer ist die Verlustleistung in den Stromquellen. Dazu wird die Spannung über den Stromquellen abhängig vom digitalen Signalprozessor der Steuereinrichtung mitgeführt.

Bei einer Kabelfehlerortung wird dem Kabel ein Spannungsimpuls zugeführt und die reflektierten Spannungen als Teilentladungen erfasst und dem Kabelende und eventuellen Fehlern im Kabel zugeordnet. Das Gerät eignet sich vorteilhafterweise als Spannungsquelle für eine Kabelmantelfehlerortung.

Vorteilhafte Ausgestaltungen der Erfindung sind in den Patentansprüchen 2 bis 13 und 15 angegeben.

Die Steuereinrichtung ist nach der Weiterbildung des Patentanspruchs 2 über eine Schalteinrichtung mit den Hauptwandlern verbunden. Zum einen liegt dabei an dem über den einen Hauptwandler mit der Steuereinrichtung verbundenen Spannungsvervielfacher eine entsprechend der Spannung des digitalen Signalprozessors geführte Spannung eines Potentials an. Zum anderen erzeugt der nicht mit der Steuereinrichtung verbundene andere Hauptwandler eine ungesteuerte Spannung des anderen Potentials. Damit liegt immer eine Spannung über den Stromquellen an. Die Schalteinrichtung selber kann ein Software- oder Hardware-Schalter sein. Darüber hinaus kann das eine Schalteinrichtung sein, wobei der positive Zweig nur auf positive Vorzeichen und der negative Zweig nur auf negative Vorzeichen der Sollwertvorgabe reagiert. Dabei wird die Verbindung physisch nicht getrennt, nur der Signalfluss wird passend gelenkt.

Die Hauptwandler sind nach der Weiterbildung des Patentanspruchs 3 so miteinander verbunden, dass die Schalter der Hauptwandler frequenzsynchron oder frequenzsynchron mit phasenverschobenen Schaltzeitpunkten zum Verringern oder Vermeiden von Schwebungseffekten und elektrischen Störbeeinflussungen schalten.

Der Hilfswandler als eine positive und eine negative Spannungsquelle umfasst einen primärseitig mit einem Transformator zusammengeschalteten Wechselrichter und sekundärseitig verbundene Spannungsvervielfacher für die positive und die negative Hochspannung.

Nach der Weiterbildung des Patentanspruchs 4 sind der Hilfswandler mit den Spannungsvervielfachern und der Hauptwandler über eine Schalteinrichtung mit den Spannungsvervielfachern verbunden. Weiterhin sind der Hauptwandler und die Schalteinrichtung so mit der Steuereinrichtung zusammengeschaltet,

- dass am über die Schalteinrichtung mit dem Hauptwandler verbundenen Spannungsvervielfacher die Spannung des Hilfswandlers und die entsprechend der Spannung des digitalen Signalprozessors geführte Spannung des Hauptwandlers jeweils eines Potentials anliegt und
- dass der andere Spannungsvervielfacher nur mit dem Hilfswandler verbunden ist, so dass an diesem Spannungsvervielfacher eine ungesteuerte Spannung des anderen Potentials anliegt. Die Spannungsvervielfacher sind dazu über Dioden entkoppelt.

Nach der Weiterbildung des Patentanspruchs 5 sind der Hilfswandler mit den Spannungsvervielfachern und der Hauptwandler über eine Schalteinrichtung mit den Spannungsvervielfachern verbunden. Der Hauptwandler und die Schalteinrichtung sind so mit der Steuereinrichtung zusammengeschaltet, dass am über die Schalteinrichtung mit dem Hauptwandler verbundenem Spannungsvervielfacher die Spannung des Hilfswandlers und die entsprechend der Spannung des digitalen Signalprozessors geführte Spannung des Hauptwandlers jeweils eines Potentials anliegt und dass der andere Spannungsvervielfacher nur mit dem Hilfswandler verbunden ist, so dass an diesem Spannungsvervielfacher eine ungesteuerte Spannung des anderen Potentials anliegt.

Der Hauptwandler ist nach der Weiterbildung des Patentanspruchs 6 so mit der Steuereinrichtung verbunden, dass der Hauptwandler während des Spannungsnulldurchgangs der Lastspannung von den Spannungsvervielfachern getrennt ist und damit nur noch der Hilfswandler autark die positive und die negative Hochspannung an den Ausgängen der Spannungsvervielfacher erzeugt und somit nur die Spannung des Hilfswandlers an den Ausgängen der Spannungsvervielfacher anliegt.

Der digitale Signalprozessor ist nach der Weiterbildung des Patentanspruchs 7 ein einen digitalen Sinus als Referenzsinus ausgebender digitaler Sinusgenerator. Darüber hinaus ist die Steuereinrichtung eine dem Referenzsinus eine Konstante zuaddierende Steuereinrichtung. Damit ist zum Einen während der positiven Halbschwingung der Lastspannung eine exakte Phasenlage und Offset zwischen der Spannung am Ausgang des positiven Spannungsvervielfachers und der positiven Halbschwingung der Lastspannung vorhanden, wobei gleichzeitig durch den Hilfswandler eine nicht synchrone und ungesteuerte negative Gleichspannung zur positiven Halbschwingung am negativem Spannungsvervielfacher erzeugt wird. Zum anderen ist während der negativen Halbschwingung der Lastspannung eine exakte Phasenlage und Offset zwischen der Spannung am Ausgang des negativen Spannungsvervielfachers und der negativen Halbschwingung der Lastspannung vorhanden, wobei gleichzeitig durch den Hilfswandler eine nicht synchrone und ungesteuerte positive Gleichspannung zur negativen Halbschwingung am positivem Spannungsvervielfacher erzeugt wird.

Der digitale Signalprozessor ist nach der Weiterbildung des Patentanspruchs 8 ein einen digitalen Sinus ausgebender digitaler Sinusgenerator. Die Steuereinrichtung ist eine die Ausgangsspannungen der Spannungsvervielfacher der Spannungsquelle abfragende und eine die neuen Sollwerte aus dem digitalen Sinusgenerator berechnende Steuereinrichtung. Weiterhin ist die Steuereinrichtung eine die Spannung über dem Kabel als Prüfling auf den neuen Sollwert aus dem digitalen Sinusgenerator regelnde Steuereinrichtung.

Der Hauptwandler ist nach der Weiterbildung des Patentanspruchs 9 ein die Netzspannung wandelnder Hauptwandler, wobei dazu ein Gleichrichter, eine Einrichtung zur Wechselspannungserzeugung mit einer Vollbrücke oder Halbbrücke und einem Resonanzkreis zur Speisung eines Transformators und der Transformator nacheinander zusammengeschaltet sind.

Der Spannungsvervielfacher ist nach der Weiterbildung des Patentanspruchs 10 eine Hochspannungskaskade als eine bekannte Greinacher-Schaltung oder als eine aus der Greinacher-Schaltung abgeleitete Hochspannungskaskade mit Vollweggleichrichtung ohne Glättungssäule.

Vorteilhafterweise ist der Schutzwiderstand nach der Weiterbildung des Patentanspruchs 11 gleichzeitig ein Entladewiderstand.

Die Stromquelle ist nach der Weiterbildung des Patentanspruchs 12 eine potentialfreie spannungsgesteuerte Stromquelle zur Steuerung der Hochspannungsquelle mit einer Reihenschaltung aus einem Widerstand und in Reihe geschalteten spannungsgesteuerten Transistoren zwischen den Potentialen und einer mit den spannungsgesteuerten Transistoren verbundenen Ansteuerschaltung mit einem optischen Empfänger und einem Operationsverstärker. Zwischen den in Reihe geschalteten spannungsgesteuerten Transistoren und dem Widerstand ist eine Zenerdiode, eine Suppressordiode oder ein Linearspannungsregler geschalten. Der freie Anschluss des Widerstandes ist ein Potential der potentialfreien spannungsgesteuerten Stromquelle. Weiterhin ist entweder die über die Zenerdiode, die Suppressordiode oder den Linearspannungsregler anliegende Spannung oder die über den Widerstand und die Zenerdiode, die Suppressordiode oder den Linearspannungsregler anliegende Spannung die Versorgungsspannung der Ansteuerschaltung.

Damit sind die potentialfreien spannungsgesteuerten Stromquellen einfach auf Hochspannungspotential liegend betreibbar.

Die Energie für die Ansteuerschaltung der Stromquelle wird aus dem Strom der durch die Stromquelle selbst fließt gewonnen. Damit kann eine ansonsten vorhandene problematische induktive Hilfsenergieübertragung entfallen. Die Signalübertragung zur Ansteuerung erfolgt einfach potentialfrei über einen Lichtwellenleiter. Der Lichtwellenleiter bietet gleichzeitig eine sehr günstige und einfache Möglichkeit der Isolation zwischen einer erdbezogenen Regelung der Stromquellen und der Ansteuerungen der Stromquellen beispielsweise in einem Hochspannungsprüfgerät.

Damit ist vorteilhafterweise

- kein Transformator zur Energieversorgung der Ansteuerschaltung notwendig.
- muss zum Fußpunkt der Ansteuerschaltung nur noch ein Lichtwellenleiter gelegt werden,

- die Isolation bei höchsten Spannungen und höchster Frequenz einfach zu realisieren und
- eine potentialfreie Stromquelle für Spannungen beliebiger Amplitude vorhanden.

Die Stromquelle kann weiterhin eine Gatespannungssymmetrierung mit in Reihe geschalteter Gatewiderstände für die in Reihe geschalteten spannungsgesteuerten Transistoren zur Symmetrierung und Bereitstellung der Ansteuerspannungen für die Gates der Transistoren aufweisen.

Der Spannungsteiler ist nach der Weiterbildung des Patentanspruchs 13 ein Hochspannungsmessteiler. Auf plattenförmigen Bauelementeträgern sind erste aus jeweils einem ohmschen Widerstand und einem Kondensator bestehende Parallelschaltungen in Reihenschaltung und auf mindestens einem der Bauelementeträger wenigstens eine zweite Parallelschaltung aus einem ohmschen Widerstand und wenigstens einem Kondensator angeordnet. Wenigstens drei Bauelementeträger sind übereinander angeordnet. Wenigstens ein Bauelementeträger weist an nach außen weisenden Kanten Feldsteuerelemente auf. Die Feldsteuerelemente sind aus einem elektrisch leitfähigen Material bestehende Zylinder- oder Rohrstücke mit als Kugelkappen ausgebildeten Endenbereichen. Dabei sind die äußeren wenigstens die ersten Parallelschaltungen aufweisenden Bauelementeträger Feldsteuerbauteile und der mittlere Bauelementeträger mit den ersten Parallelschaltungen und der zweiten Parallelschaltung der Messspannungsteiler, wobei die Verbindung zwischen den ersten Parallelschaltungen und der zweiten Parallelschaltung des Messspannungsteilers der Abgriff des Hochspannungsmessteilers und die ersten Parallelschaltungen der Feldsteuerbauteile und die Reihenschaltung aus ersten Parallelschaltungen und zweiter Parallelschaltung des Messspannungsteilers parallel zueinander geschalten die weiteren Anschlüsse des Hochspannungsmessteilers sind.

Die Hochspannungsmessteiler zeichnen sich insbesondere durch eine weitest gehende Unabhängigkeit von parasitären Elementen aus.

Damit ist der Hochspannungsmessteiler weitestgehend unabhängig von parasitären Ableitwiderständen, von der parasitären Erdkapazität und von den elektrischen und dielektrischen Eigenschaften des Isoliermediums.

Ein realer Spannungsteiler hat als körperlicher Gegenstand eine Oberfläche, die mit der Fläche der Erdelektrode eine Kapazität bildet. Das Medium zwischen Spannungsteiler und Erdelektrode besitzt einen spezifischen elektrischen Widerstand. Dadurch ergibt sich ein Widerstand zwischen der Oberfläche des Spannungsteilers und der Fläche der Erdelektrode, der im Folgenden parasitärer Ableitwiderstand genannt wird. Der Ableitwiderstand ergibt sich aus dem Produkt aus dem spezifischen Widerstand und dem Verhältnis aus Länge zu Fläche.

Ein Hochspannungsprüfgerät mit einer kompakten Bauform erzwingt die Isolation der Hochspannungskomponenten gegen die Erdelektrode mit Isoliermedien beispielsweise von Vergussmassen. Es entsteht immer eine räumliche Nähe zur Erdelektrode. Dadurch werden die parasitären Einflüsse der Erdkapazität und des Ableitwiderstandes begünstigt.

Die parasitäre Erdkapazität vergrößert sich naturgesetzlich um den Faktor des Wertes der Dielektrizitätskonstante des Isoliermediums. Die Dielektrizitätskonstanten von festen oder flüssigen Isoliermedien haben die Eigenschaft, für den notwendigen Temperatureinsatzbereich nicht stabil zu sein. Die parasitäre Erdkapazität ist dadurch über die Temperatur nicht konstant.

Die spezifischen elektrischen Widerstände von festen oder flüssigen Isoliermedien haben die Eigenschaft, für den notwendigen Temperatureinsatzbereich nicht stabil zu sein. Der parasitäre Ableitwiderstand ist dadurch über die Temperatur nicht konstant. Besonders bei festen Isoliermedien mit einer hohen Wärmeleitfähigkeit ist die Temperaturinstabilität der dielektrischen Werte gravierend.

Durch den parasitären Ableitwiderstand wird die lineare Spannungsverteilung über dem Spannungsteiler verfälscht und durch die parasitäre Erdkapazität wird die Phasenlage der Ausgangsspannung verfälscht. Somit ist keine korrekte Aussage über die Amplitude und die Phasenlage in der Messerfassung der Ausgangsspannung mehr möglich.

Dadurch ist eine hochpräzise Verlustfaktor-Messung (tan Delta) nicht mehr möglich.

Der Hochspannungsmessteiler zeichnet sich vorteilhafterweise dadurch aus, dass ein Einfluss der parasitären Elemente unterbunden wird. Er besteht im Wesentlichen aus der Reihenschaltung der ersten Parallelschaltungen und der wenigstens einen zweiten Parallelschaltung. Durch das Parallelschalten der drei beabstandet zueinander angeordneten Bauelementeträger ist der mittlere Bauelementeträger als Messspannungsteiler mit den Reihenschaltungen von ersten Parallelschaltungen aus einem ohmschen Widerstand und einem Kondensator und die zweite Parallelschaltung in einem "feldfreien" Raum eingebettet. Die Äußeren fungieren als Feldsteuerelemente.

Mittels des Hochspannungsmessteilers ist dadurch die korrekte Phasenlage und die korrekte Amplitude der Spannung unabhängig von äußeren Temperatureinflüssen und unabhängig von der Einbaulage in einem Gerät messbar.

Der Hochspannungsmessteiler ist somit unabhängig vom parasitären Ableitwiderstand, von der parasitären Erdkapazität und von den elektrischen und dielektrischen Eigenschaften des Isoliermediums.

Eine hochpräzise Verlustfaktor-Messung (tan Delta) ist ohne zusätzliche nachträgliche Korrekturen möglich.

Das so vorhandene Grundprinzip einer quasi Umhüllung oder Schirmung des Hochspannungsmessteilers durch gleichartige Bauelementeträger mit Spannungsteilern kann auch für große Hochspannungsmessteiler angewendet werden, die in Freiluft aufgestellt werden.

Die Bauelemente der parallel geschalteten schirmenden äußeren Bauelementeträger mit Spannungsteilern können auch anderes dimensioniert werden als der mittlere und eigentliche Messspannungsteiler. Damit kann beispielsweise die gesamte Verlustleistung in den Widerständen gering gehalten werden.

Die Umhausung, die Stromquellen, die Steuereinrichtung, die Koppeldioden, der Schutzwiderstand und der Spannungsteiler sind nach der Weiterbildung des Patentanspruchs 15 in einem mit Erdpotential verbundenem oder verbindbarem Gehäuse angeordnet, so dass das Gerät ein mobiles Gerät ist oder sich das Gerät in einem Fahrzeug befindet.

Ein Ausführungsbeispiel der Erfindung ist in den Zeichnungen jeweils prinzipiell dargestellt und werden im Folgenden näher beschrieben.

Es zeigen:

Fig. 1    eine Schaltungsanordnung zur Kabelprüfung, Kabeltestung, Kabeldiagnose und/oder Kabelfehlerortung mit einem Hauptwandler und einem Hilfswandler,

Fig. 2    eine Schaltungsanordnung zur Kabelprüfung, Kabeltestung, Kabeldiagnose und/oder Kabelfehlerortung mit realisiertem Hauptwandler und Hilfswandler,

Fig. 3    eine Schaltungsanordnung eines Hilfswandlers,

Fig. 4    Kurvenverläufe im Zeitbereich,

Fig. 5    ein unterteilter Kurvenverlauf,

Fig. 6    eine Schaltungsanordnung zur Kabelprüfung, Kabeltestung, Kabeldiagnose und/oder Kabelfehlerortung mit zwei Hauptwandlern,

Fig. 7    eine potentialfreie spannungsgesteuerte Stromquelle zur Steuerung von Hochspannungsquellen,

Fig. 8    eine potentialfreie spannungsgesteuerte Stromquelle zur Steuerung von Hochspannungsquellen, wobei der Strom zur Versorgung der Ansteuerschaltung ein Bestandteil des vorgegebenen Sollwertes ist,

Fig. 9    eine potentialfreie spannungsgesteuerte Stromquelle mit einer Einrichtung zur Überwachung des Stromes in den Gatewiderständen der Transistoren,

Fig. 10    ein Schaltbild eines Hochspannungsmessteilers,

Fig. 11    ein Bauelementeträger mit Widerständen und Kondensatoren als Spannungsteiler in einer Draufsicht,

Fig. 12    ein Hochspannungsmessteiler in einer Seitenansicht und

Fig. 13    ein Feldsteuerelement an einer Leiterplatte.

Eine Schaltungsanordnung zur Kabelprüfung, Kabeltestung, Kabeldiagnose und/oder Kabelfehlerortung besteht im Wesentlichen aus einer Spannungsquelle 1, einer Messimpedanz 22, Stromquellen 2, 3, einem Spannungsteiler 5, einem Schutzwiderstand 6, einer Steuereinrichtung 7, Koppeldioden 8, 9 in Verbindung mit einem Kabel (4) als Prüfling.

Mit der Spannungsquelle 1 wird in Verbindung mit den Stromquellen 2, 3 und der Steuereinrichtung 7 eine Prüfspannung erzeugt. Diese kann über der Lastimpedanz des Kabels 4 zum Aufladen und zum Entladen der Lastkapazität des Kabels 4 erzeugt werden. Dazu sind die miteinander verbundenen Stromquellen 2, 3 über den Schutzwiderstand 6 mit dem Kabel 4 und dem Spannungsteiler 5 verbunden. Die Steuereinrichtung 7 weist einen digitalen Signalprozessor zur Regelung der über den Spannungsteiler 5 gemessenen Prüfspannung über der Lastimpedanz des Kabels 4 und zur Sollwertvorgabe der Spannungsquelle 1 auf.

In einer ersten Ausführungsform des Ausführungsbeispiels weist die Spannungsquelle 1 einen Hauptwandler 10, einen Hilfswandler 11, eine Schalteinrichtung 12 und einen ersten Spannungsvervielfacher 13 für eine positive Spannung und einen zweiten Spannungsvervielfacher 14 für eine negative Spannung auf.

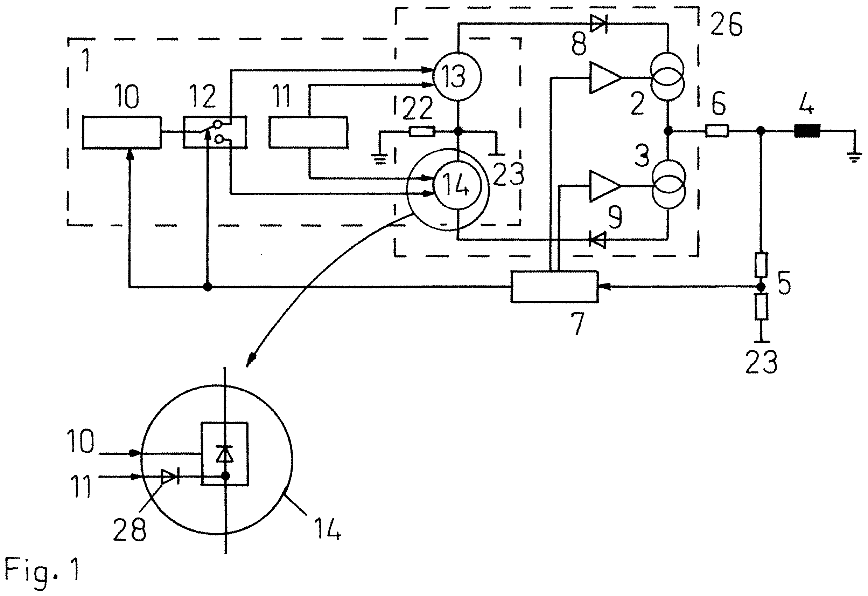

Die Fig. 1 zeigt eine Schaltungsanordnung zur Kabelprüfung, Kabeltestung, Kabeldiagnose und/oder Kabelfehlerortung mit einem Hauptwandler 10 und einem Hilfswandler 11 in einer prinzipiellen Darstellung.

Der erste Spannungsvervielfacher 13 für eine positive Spannung und der zweite Spannungsvervielfacher 14 für eine negative Spannung der Spannungsquelle 1 sind über die Koppeldioden 8, 9 mit den miteinander verbundenen Stromquellen 2, 3 unter Bildung eines Zwischenkreises 26 mit einer Zwischenkreisspannung zusammengeschalten. Die Koppeldioden 8, 9 verhindern das Rückwärtsspeisen der Spannungsvervielfacher 13, 14.

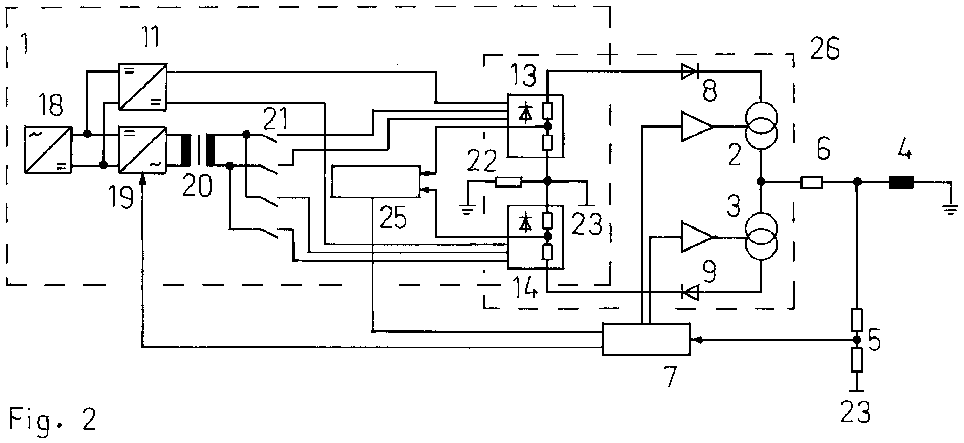

Die Fig. 2 zeigt eine Schaltungsanordnung zur Kabelprüfung, Kabeltestung, Kabeldiagnose und/oder Kabelfehlerortung mit realisiertem Hauptwandler 10 und Hilfswandler 11 in einer prinzipiellen Darstellung.

Die Spannungsvervielfacher 13, 14 sind mit sowohl einem Hauptwandler 10 als auch einem eine positive und eine negative Hilfsspannung erzeugenden Hilfswandler 11 so verbunden, dass an den Ausgängen der Spannungsvervielfacher 13, 14 entweder eine entsprechend der Sollwertvorgabe positive Spannung und eine konstante ungesteuerte negative Spannung oder eine entsprechend der Sollwertvorgabe negative Spannung und eine konstante ungesteuerte positive Spannung anliegen, wobei die jeweilig ungesteuerte Spannung durch den ungesteuerten Hilfswandler 11 erzeugt wird. Damit liegt immer eine Spannung als eine Mindestspannung über den Stromquellen 2, 3 an. Der Hilfswandler 11 ist über Dioden 28 mit Spannungsvervielfachern 13, 14 verbunden.

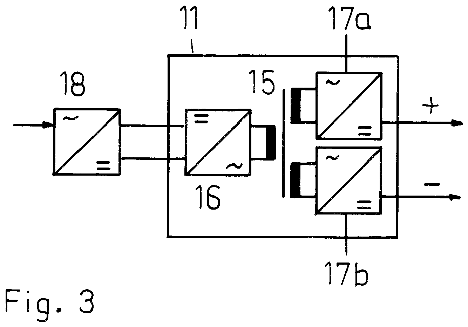

Die Fig. 3 zeigt eine Schaltungsanordnung eines Hilfswandlers 11 in einer prinzipiellen Darstellung.

Der Hilfswandler 11 als eine positive und eine negative Spannungsquelle weist dazu einen primärseitig mit einem Transformator 15 zusammengeschalteten Wechselrichter 16 und sekundärseitig verbundene Spannungsvervielfacher 17a, 17b für die positive und die negative Spannung auf.

Der Hauptwandler 10 ist ein die Netzspannung wandelnder Hauptwandler 10, wobei dazu ein Gleichrichter 18, eine Einrichtung 19 zur Wechselspannungserzeugung mit einer Vollbrücke oder Halbbrücke und einem Resonanzkreis zur Speisung eines Transformators 20, der Transformator 20 und Relais 21 zur Kontaktierung des benötigten Spannungsvervielfachers 13, 14 nacheinander zusammengeschaltet sind. Der Gleichrichter 18 ist dazu gleichzeitig der Gleichrichter für den Hilfswandler 11.

Die Spannungsvervielfacher 13, 14 sind zum einen mit dem Hilfswandler 11 und zum anderen über die Schalteinrichtung 12 mit dem Hauptwandler 10 verbunden. Die Betätigung der Schalteinrichtung 12 erfolgt mittels der Steuereinrichtung 7, so dass

- am über die Schalteinrichtung 12 mit dem Hauptwandler 10 verbundenem Spannungsvervielfacher 13, 14 die Spannung des Hilfswandlers 11 und die entsprechend der Spannung des digitalen Signalprozessors geführte Spannung des Hauptwandlers 10 jeweils eines Potentials anliegt und
- der andere Spannungsvervielfacher 13, 14 nur mit dem Hilfswandler 11 verbunden ist, so dass an diesem Spannungsvervielfacher 13, 14 eine ungesteuerte Spannung des anderen Potentials anliegt.

Zur Ermittlung der Spannungen der Spannungsvervielfacher 13, 14 sind Spannungsteiler 24 vorhanden. Die Spannungswerte werden mittels einer Messwerterfassung 25 erfasst und durch die Steuereinrichtung 7 abgefragt.

Die beiden miteinander verbundenen Bezugspotentiale der Spannungsvervielfacher 13, 14 sind über eine an den Messbereich anpassbare Messimpedanz 22 mit dem Bezugspotential des Kabels 4 verbunden, wobei die Bezugspotentiale der Spannungsvervielfacher 13, 14 und das Bezugspotential des Spannungsteilers 5 eine Hilfserde 23 sind. Mittels der Messimpedanz 22 kann eine optimale Einstellung des Messbereichs erfolgen. Diese kann dazu aus mehreren schaltbaren Widerständen und Kondensatoren bestehen.

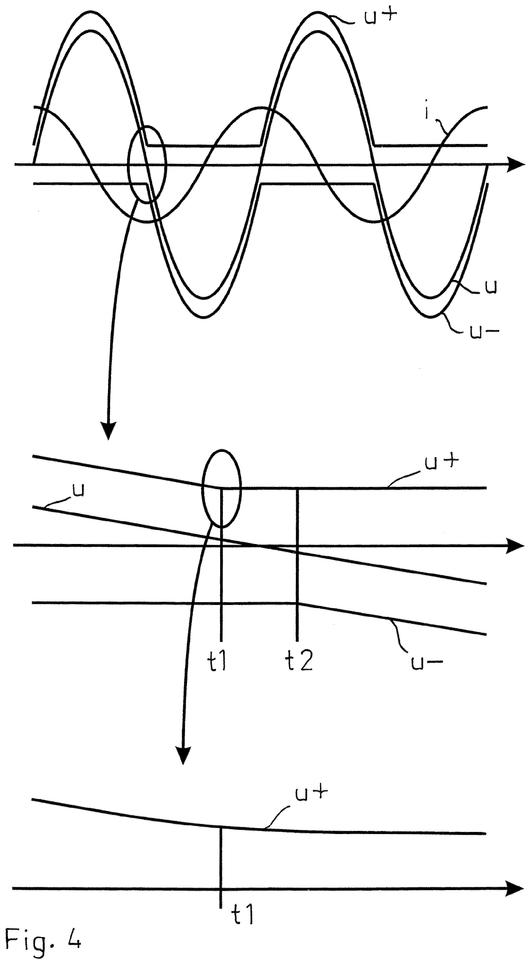

Die Fig. 4 zeigt Kurvenverläufe im Zeitbereich in einer prinzipiellen Darstellung.

Der digitale Signalprozessor kann in einer Ausführungsvariante der ersten Ausführungsform des Ausführungsbeispiels ein einen digitalen Sinus als Referenzsinus ausgebender digitaler Sinusgenerator sein. Der Hauptwandler 10 ist mit der Steuereinrichtung 7 so verbunden, dass der Hauptwandler 10 während des Spannungsnulldurchgangs der Lastspannung von den Spannungsvervielfachern 13, 14 getrennt ist und damit nur noch der Hilfswandler 11 autark die positive und die negative Spannung an den Ausgängen der Spannungsvervielfachern 13, 14 erzeugt und somit nur die Spannung des Hilfswandlers 11 an den Ausgängen der Spannungsvervielfacher 13, 14 anliegt.

Die Fig. 4 zeigt in

a) die Kurvenverläufe des Zeitbereichs,
b) einen Ausschnitt, wobei im Zeitbereich t1 bis t2 nur der Hilfswandler 11 aktiv ist und
c) einen nochmals vergrößerten Ausschnitt zum Zeitpunkt t1, wobei der Verlauf der Spannung u+ zu jedem Zeitpunkt einer differenzierbaren Funktion entspricht. Gleiches gilt für die Spannung u- zum Zeitpunkt t2.

Die Vorlaufspannung sollte einer an allen Stellen differenzierbaren Funktion entsprechen, das heißt der Verlauf der Vorlaufspannung ist knickfrei. Diese Forderung wird durch eine entsprechende Programmierung in der Steuereinrichtung 7 autonom von der Hochspannungsquelle 1 erfüllt oder wird bereits in der Sollwertvorgabe berücksichtigt.

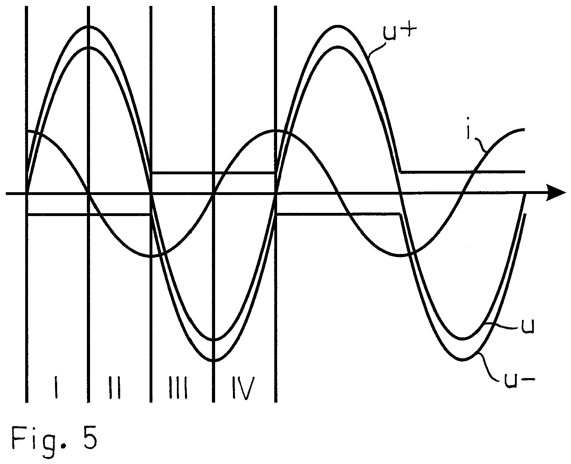

Fig. 5 zeigt einen unterteilten Kurvenverlauf in einer prinzipiellen Darstellung.

Zur Verdeutlichung ist in der Fig. 5 eine Verlustleistungsbetrachtung dargestellt. Dazu ist eine Periode in die Bereiche I, II, III und IV aufgeteilt. Dabei gilt:

Bereich I Aufladen der Kapazität auf eine positive Spannung

$$P_V = \left| i \cdot \left( u^+ - u \right) \right|$$

diese Verlustleistung entsteht in der Stromquelle 2
Bereich II Entladen der Kapazität

$$P_V = \left| i \cdot \left( u - u^- \right) \right|$$

diese Verlustleistung entsteht in der Stromquelle 3
Bereich III Aufladen der Kapazität auf eine negative Spannung

$$P_V = \left| i \cdot \left( u - u^- \right) \right|$$

diese Verlustleistung entsteht in Stromquelle 3
Bereich IV Entladen der Kapazität

$$P_V = \left| i \cdot \left( u^+ - u \right) \right|$$

diese Verlustleistung entsteht in Stromquelle 2

Diese Verlustleistungsbetrachtungen sind idealisiert. Zusätzliche Verlustleistungen durch beispielsweise den Querstrom sind nicht von Bedeutung und werden daher nicht genauer betrachtet.

Wie zu sehen sind die für die Verlustleistung verantwortlichen Differenzen $|u^+-u|$ und $|u^--u|$ deutlich klein.

Die Steuereinrichtung 7 kann eine dem Referenzsinus eine Konstante zuaddierende Steuereinrichtung 7 sein, so dass

- zum einen während der positiven Halbschwingung der Lastspannung eine exakte Phasenlage und Offset zwischen der Spannung am Ausgang des positiven Spannungsvervielfachers 13 und der positiven Halbschwingung der Lastspannung vorhanden ist, wobei gleichzeitig durch den Hilfswandler 11 eine nicht synchrone und ungesteuerte negative Gleichspannung zur positiven Halbschwingung am negativem Spannungsvervielfacher 14 erzeugt wird, und

- zum anderen während der negativen Halbschwingung der Lastspannung eine exakte Phasenlage und Offset zwischen der Spannung am Ausgang des negativen Spannungsvervielfachers 14 und der negativen Halbschwingung der Lastspannung vorhanden ist, wobei gleichzeitig durch den Hilfswandler 11 eine nicht synchrone und ungesteuerte positive Gleichspannung zur negativen Halbschwingung am positivem Spannungsvervielfacher 13 erzeugt wird.

In einer zweiten Ausführungsform des Ausführungsbeispiels weist die Spannungsquelle 1 einen ersten Hauptwandler 10a, einen zweiten Hauptwandler 10b, eine Schalteinrichtung 12 und den ersten Spannungsvervielfacher 13 für eine positive Spannung und den zweiten Spannungsvervielfacher 14 für eine negative Spannung auf.

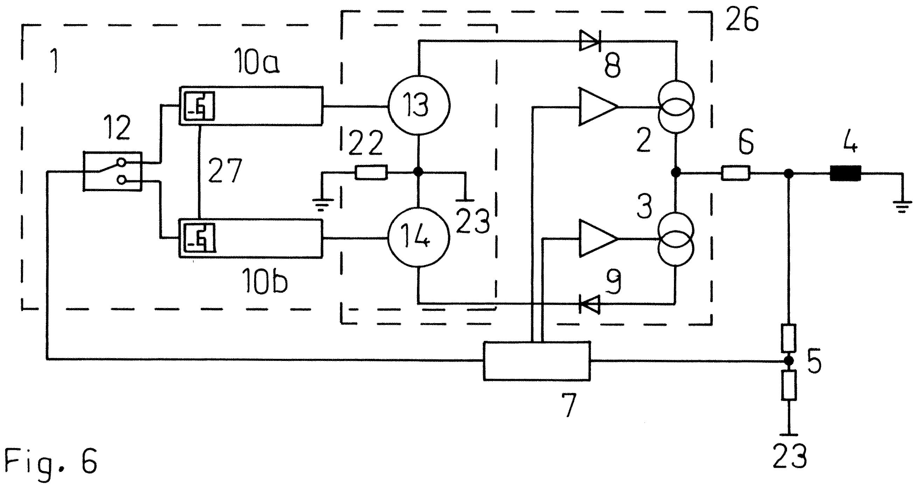

Die Fig. 6 zeigt eine Schaltungsanordnung zur Kabelprüfung, Kabeltestung, Kabeldiagnose und/oder Kabelfehlerortung mit zwei Hauptwandlern 10a, 10b in einer prinzipiellen Darstellung.

Die Hauptwandler 10a, 10b entsprechen jeweils in ihrer Funktion dem Hauptwandler 10 der ersten Ausführungsform des Ausführungsbeispiels.

Die Spannungsvervielfacher 13, 14 sind mit den Hauptwandlern 10a, 10b so verbunden, dass an den Ausgängen der Spannungsvervielfacher 13, 14 entweder eine entsprechend der Sollwertvorgabe positive Spannung des Hauptwandlers 10a und eine konstante ungesteuerte negative Spannung des Hauptwandlers 10b oder eine entsprechend der Sollwertvorgabe negative Spannung des Hauptwandlers 10b und eine konstante ungesteuerte positive Spannung des Hauptwandlers 10a anliegen. Der erste Spannungsvervielfacher 13 für eine positive Spannung und der zweite Spannungsvervielfacher 14 für eine negative Spannung der Spannungsquelle 1 sind über die Koppeldioden 8, 9 mit den miteinander verbundenen Stromquellen 2, 3 unter Bildung eines Zwischenkreises 26 mit einer Zwischenkreisspannung zusammengeschaltet. Die Koppeldioden 8, 9 verhindern das Rückwärtsspeisen der Spannungsvervielfacher 13, 14.

Die jeweilig ungesteuerte Spannung wird durch den jeweiligen Hauptwandler 10a, 10b erzeugt. Dazu ist die Steuereinrichtung 7 über die Schalteinrichtung 12 mit den Hauptwandlern 10a, 10b so verbunden,

- dass am über den einen Hauptwandler 10a, 10b mit der Steuereinrichtung 7 verbundenem Spannungsvervielfacher 13, 14 eine entsprechend der Spannung des digitalen Signalprozessors geführte Spannung eines Potentials anliegt und

- dass der nicht mit der Steuereinrichtung 7 verbundene andere Hauptwandler 10a, 10b eine ungesteuerte Spannung des anderen Potentials erzeugt. Damit liegt immer eine Spannung als Mindestspannung über den Stromquellen 2, 3 an.

Die Hauptwandler 10a, 10b können über eine Verbindung 27 so miteinander zusammengeschaltet sein, dass die Schalter der Hauptwandler 10a, 10b frequenzsynchron oder frequenzsynchron mit phasenverschobenen Schaltzeitpunkten zum Verringern oder Vermeiden von Schwebungseffekten und elektrischen Störbeeinflussungen schalten.

Zur Ermittlung der Spannungen der Spannungsvervielfacher 13, 14 sind Spannungsteiler 24 vorhanden. Die Spannungswerte werden mittels einer Messwerterfassung 25 erfasst und durch die Steuereinrichtung 7 abgefragt.

Die beiden miteinander verbundenen Bezugspotentiale der Spannungsvervielfacher 13, 14 sind über die an den Messbereich anpassbare Messimpedanz 22 mit dem Bezugspotential des Kabels 4 verbunden, wobei die Bezugspotentiale der Spannungsvervielfacher 13, 14 und das Bezugspotential des Spannungsteilers 5 eine Hilfserde 23 sind. Mittels der Messimpedanz 22 kann eine optimale Einstellung des Messbereichs erfolgen. Diese kann dazu aus mehreren schaltbaren Widerständen und Kondensatoren bestehen.

Die Darstellung der Fig. 5 zeigt einen unterteilten Kurvenverlauf im Zeitbereich in einer prinzipiellen Darstellung.

Der digitale Signalprozessor kann in einer Ausführungsvariante der zweiten Ausführungsform ein einen digitalen Sinus als Referenzsinus ausgebender digitaler Sinusgenerator sein. Die Steuereinrichtung 7 ist

- eine die Ausgangsspannungen der Spannungsvervielfacher 13, 14 der Spannungsquelle 1 abfragende,

- eine die neuen Sollwerte aus dem digitalen Sinusgenerator berechnende und

- eine die Spannung über dem Kabel 4 als Prüfling auf den neuen Sollwert aus dem digitalen Sinusgenerator regelnde Steuereinrichtung 7.

Zur Verdeutlichung ist in der Fig. 5 eine Verlustleistungsbetrachtung dargestellt. Dazu ist eine Periode in die Bereiche I, II, III und IV aufgeteilt. Dabei gilt das in der ersten Ausführungsform aufgeführte.

Die Steuereinrichtung 7 kann eine dem Referenzsinus eine Konstante zuaddierende Steuereinrichtung 7 sein, so dass

- zum einen während der positiven Halbschwingung der Lastspannung eine exakte Phasenlage und Offset zwischen der Spannung am Ausgang des positiven Spannungsvervielfachers 13 und der positiven Halbschwingung der Lastspannung vorhanden ist, wobei gleichzeitig durch den negativen Spannungsvervielfacher 14 eine nicht synchrone und ungesteuerte negative Gleichspannung erzeugt wird, und
- zum anderen während der negativen Halbschwingung der Lastspannung eine exakte Phasenlage und Offset zwischen der Spannung am Ausgang des negativen Spannungsvervielfachers 14 und der negativen Halbschwingung der Lastspannung vorhanden ist, wobei gleichzeitig durch den positiven Spannungsvervielfacher 13 eine nicht synchrone und ungesteuerte positive Gleichspannung erzeugt wird.

Die beiden miteinander verbundenen Bezugspotentiale der Spannungsvervielfacher 13, 14 sind über die Messimpedanz 22 mit dem Bezugspotential des Kabels als Prüfling verbunden, wobei die Bezugspotentiale der Spannungsvervielfacher 13, 14 und das Bezugspotential des Spannungsteilers 5 eine Hilfserde 23 sind.

Die Spannungsvervielfacher 13, 14 der Ausführungsformen des Ausführungsbeispiels sind Hochspannungskaskaden, die als eine Greinacher-Schaltung oder als eine aus der Greinacher-Schaltung abgeleitete Spannungsvervielfacher mit Vollweggleichrichtung ohne Glättungssäule ausgebildet sein können.

Darüber hinaus ist der Schutzwiderstand 6 gleichzeitig ein Entladewiderstand.

Die Spannungsquellen 1 der Ausführungsformen des Ausführungsbeispiels befinden sich bei einem Gerät jeweils in einer abgeschirmten Umhausung, die die Hilfserde 23 ist. Das Anschlusskabel des Kabels 4 ist ein abgeschirmtes Anschlusskabel, wobei die Abschirmung des Anschlusskabels mit der Hilfserde 23 verbunden sind. Die Umhausung, die Stromquellen 2, 3, die Steuereinrichtung 7, die Koppeldioden 8, 9, der Schutzwiderstand 6 und der Spannungsteiler 5 sind in einem mit Erdpotential verbundenem oder verbindbarem Gehäuse angeordnet, so dass das Gerät ein mobiles Gerät ist oder sich das Gerät in einem Fahrzeug befindet.

Eine potentialfreie spannungsgesteuerte Stromquelle zur Steuerung von Hochspannungsquellen des Ausführungsbeispiels kann im Wesentlichen aus spannungsgesteuerten Transistoren T1, T2, ... TN mit Gatewiderständen RG1, RG2, ... RGN, einer Ansteuerschaltung 29, einem Widerstand R und einer Zenerdiode ZD bestehen.

Bei einer Reihenschaltung einer beliebigen Anzahl von spannungsgesteuerten Transistoren T1, T2, ... TN kann entsprechend der Sperrfähigkeit der Transistoren T1, T2, ... TN eine Spannung V bis zu mehreren 100 kV anliegen. Diese Spannung V kann auch als Vorlaufspannung bezeichnet werden. Die spannungsgesteuerten Transistoren T1, T2, ... TN sind beispielsweise bekannte MOSFET's (Metall-Oxid-Halbleiter-Feldeffekttransistor) oder IGBT's (insulated-gate bipolar transistor, Bipolartransistor mit isolierter Gate-Elektrode). Mit Hilfe der mit den Gates verbundenen Gatewiderstände RG1, RG2, ... RGN wird die Spannung zur Ansteuerung der Transistoren T1, T2, ... TN bereitgestellt und symmetriert, so dass auch von einer Gatespannungssymmetrierung gesprochen werden kann. Der Strom i_Gate durch die Gatewiderstände RG1, RG2, ... RGN ergibt sich nach dem ohmschen Gesetz. Die Leckströme in die Gates der Transistoren T1, T2, ... TN sind vernachlässigbar klein. Mit Hilfe der Ansteuerschaltung 29 wird das Gate des untersten Transistors T1 angesteuert. Durch die Gatewiderstände RG1, RG2, ... RGN der Gatespannungssymmetrierung werden darauf hin auch die Gates aller darüber liegenden Transistoren T2, ... TN passend angesteuert. Mit Gateansteuerung ist dabei gemeint, dass die Gate-Source-Spannung bei MOSFET oder die Gate-Emitter-Spannung bei IGBT exakt auf die Amplitude eingestellt wird, um den gewünschten Strom i zu erhalten. Die Transistoren T1, T2, ... TN müssen dabei für diese Art der Stromquelle notwendigerweise immer im Linearbetrieb arbeiten.

Die Reihenschaltung der spannungsgesteuerten Transistoren T1, T2, ... TN und der Widerstand R sind in Reihe zwischen den Potentialen V, 35 geschaltet. Zwischen den in Reihe geschalteten Transistoren T1, T2, ... TN und dem Widerstand R ist die Zenerdiode ZD geschalten. Der freie Anschluss des Widerstandes R ist ein Potential und hier der Fußpunkt der potentialfreien spannungsgesteuerten Stromquelle. Die über die Zenerdiode ZD anliegende Spannung oder die über den Widerstand R und der Zenerdiode ZD anliegende Spannung ist die Versorgungsspannung V+ der Ansteuerschaltung 29. Die Widerstände sind ohmsche Widerstände.

Die Ansteuerschaltung 29 weist dazu

- einen optischen Empfänger 30 für einen Lichtwellenleiter 34, der das Licht aus einer Regelung für die Ausgangsspannung der potentialfreien spannungsgesteuerten Stromquelle in ein elektrisches Signal wandelt,
- einen Demodulator 31, der das elektrische Signal in die notwendige Sollspannung u_Soll für den nichtinvertierenden Eingang eines Operationsverstärkers 32 wandelt,

-　dem Operationsverstärker 32 zur Generierung der notwendigen Gateansteuerung und

-　einen Pegelanpasser 33 zum Aufsteuern des mit der Zenerdiode ZD verbundenen spannungsgesteuerten Transistors T1 als ersten der in Reihe geschalteten spannungsgesteuerten Transistoren T1

auf.

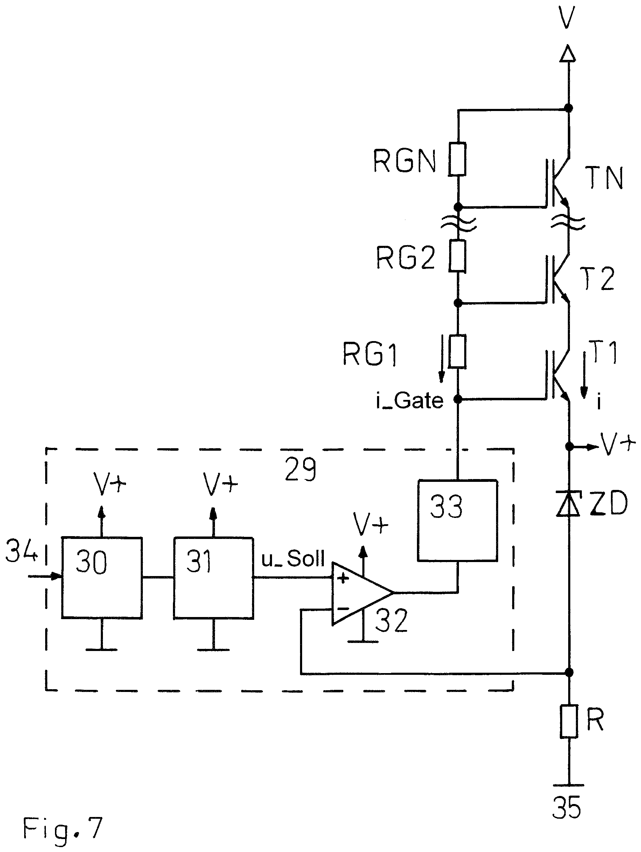

Die Fig. 7 zeigt eine spannungsgesteuerte Stromquelle zur Steuerung von Hochspannungsquellen in einer prinzipiellen Darstellung.

In einer ersten Ausführungsform der potentialfreien spannungsgesteuerten Stromquelle ist der invertierende Eingang des Operationsverstärkers 32 mit der Verbindung des Widerstands R und der Zenerdiode ZD zusammengeschaltet. Damit fließt der Strom zur Versorgung der Ansteuerschaltung 29 am Widerstand R vorbei und zusätzlich zur Sollwertvorgabe. Der Fußpunkt 35 der Stromquelle ist gleichzeitig das Bezugspotential der Ansteuerschaltung 29.

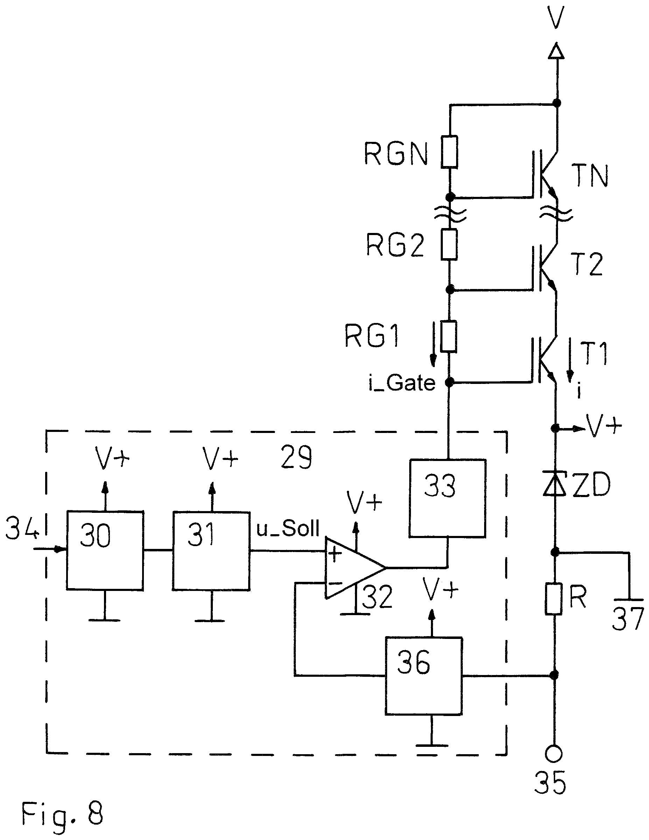

Die Fig. 8 zeigt eine spannungsgesteuerte Stromquelle zur Steuerung von Hochspannungsquellen, wobei der Strom zur Versorgung der Ansteuerschaltung 29 ein Bestandteil des vorgegebenen Sollwertes ist, in einer prinzipiellen Darstellung.

In einer zweiten Ausführungsform der potentialfreien spannungsgesteuerten Stromquelle ist der invertierende Eingang des Operationsverstärkers 32 über einen invertierenden Verstärker 36 als weiterer Bestandteil der Ansteuerschaltung 29 mit dem Fußpunkt 35 der Stromquelle zusammengeschaltet. Die Verbindung des Widerstands R und der Zenerdiode ZD ist das Bezugspotential 37 der Ansteuerschaltung 29, so dass der Strom zur Versorgung der Ansteuerschaltung 29 durch den Widerstand R geleitet wird. Damit ist der Strom zur Versorgung der Ansteuerschaltung 29 ein Bestandteil des vorgegebenen Sollwertes.

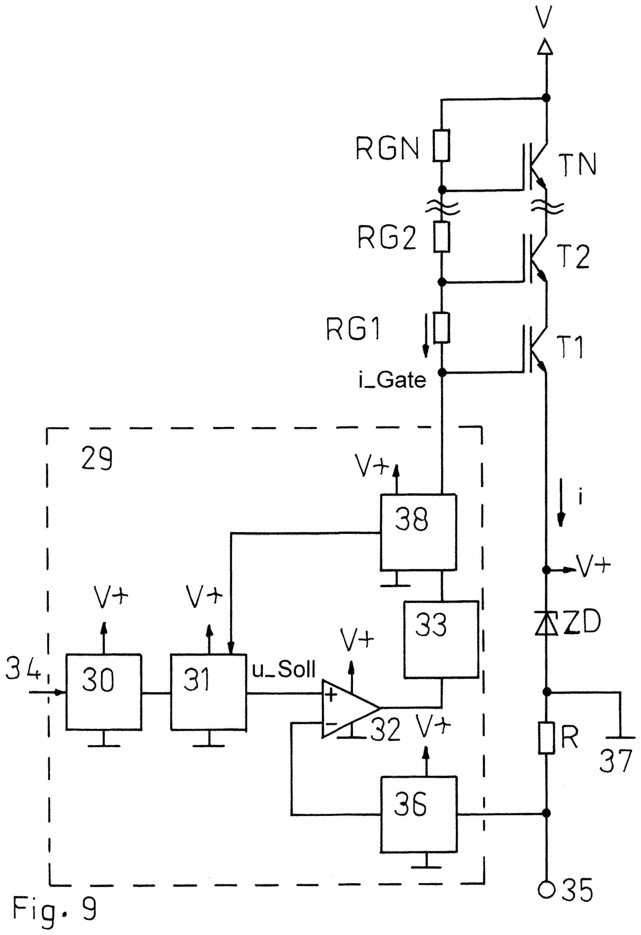

Die Fig. 9 zeigt eine potentialfreie spannungsgesteuerte Stromquelle mit einer Einrichtung 38 zur Überwachung des Stromes in den Gatewiderständen RG1, RG2, ... RGN der Transistoren T1, T2, ... TN in einer prinzipiellen Darstellung.

In einer dritten Ausführungsform der potentialfreien spannungsgesteuerten Stromquelle ist der invertierende Eingang des Operationsverstärkers 32 über einen invertierenden Verstärker 36 als weiterer Bestandteil der Ansteuerschaltung 29 mit dem Fußpunkt 35 der Stromquelle verbunden. Die Verbindung des Widerstands R und der Zenerdiode ZD ist das Bezugspotential 37 der Ansteuerschaltung 29, so dass der Strom zur Versorgung der Ansteuerschaltung 29 durch den Widerstand R geleitet wird. Damit ist der Strom zur Versorgung der Ansteuerschaltung 29 ein Bestandteil des vorgegebenen Sollwertes. Der Ausgang des Operationsverstärkers 32 ist über den Pegelanpasser 33 und einer Einrichtung 38 zur Überwachung des Stromes in den Gatewiderständen RG1, RG2, ... RGN der Transistoren T1, T2, ... TN und damit der Gatespannungssymmetrierung zusammengeschaltet. Diese Einrichtung 38 als weiterer Bestandteil der Ansteuerschaltung 29 ist mit dem Demodulator 31 verbunden, so dass ein Rückschluss auf die Vorlaufspannung der Stromquelle gegeben ist.

Anstelle der Zenerdiode ZD kann in weiteren Ausführungsformen der potentialfreien spannungsgesteuerten Stromquellen auch eine Suppressordiode oder ein Linearspannungsregler eingesetzt werden.

Die Transistoren T1, T2, ... TN sind bekannterweise vor elektromagnetischen Einflüssen geschützt. Dazu werden diese mit Schutzelementen, beispielsweise Suppressordioden, als Überspannungsableiter versehen.

Für eine Hochspannungsquelle 1 mit einer positiven und einer negativen Hochspannung können zwei potentialfreie spannungsgesteuerte Stromquellen zusammengeschaltet sein. Eine erste Reihenschaltung aus dem Widerstand R und der in Reihe geschalteten spannungsgesteuerten Transistoren T1, T2, ... TN ist zwischen einem Bezugspotential für eine Last und der positiven Hochspannung geschalten. Die zweite Reihenschaltung aus dem Widerstand R und der in Reihe geschalteten spannungsgesteuerten Transistoren T1, T2, ... TN ist zwischen der negativen Hochspannung und dem Bezugspotential für die Last geschalten. Das Bezugspotential der Last ist dabei die Verbindung zwischen Widerstand der ersten Reihenschaltung und letztem spannungsgesteuerten Transistor TN der zweiten Reihenschaltung.

In Fortführung können für eine potentialfreie Hochspannungsquelle 1 zwei derartige aus zwei miteinander verbundenen potentialfreien spannungsgesteuerten Stromquellen bestehende Stromquellenanordnungen parallel zueinander angeordnet und mit der Hochspannungsquelle 1 als Parallelschaltung verbunden sein. Das Kabel 4 ist dabei zwischen die Bezugspotentiale der miteinander verbundenen Stromquellen geschaltet.

Der Spannungsteiler 5 des Ausführungsbeispiels und damit der Ausführungsformen kann ein Hochspannungsmessteiler 39 sein. Ein derartiger besteht im Wesentlichen aus plattenförmigen Bauelementeträgern als Leiterplatten 40 mit Widerständen R und Kondensatoren C sowie Feldsteuerelementen 41.

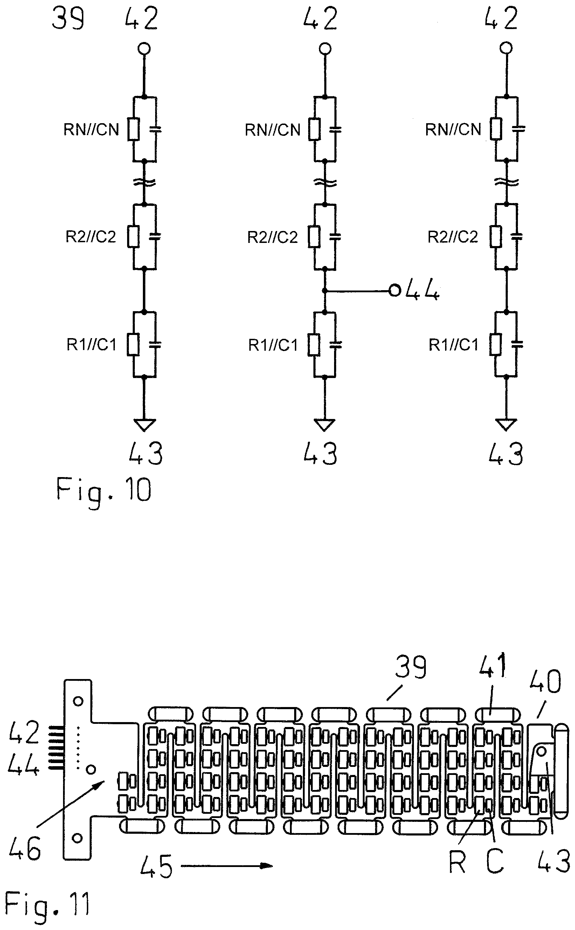

Die Fig. 10 zeigt ein Schaltbild eines Hochspannungsmessteilers 39 in einer prinzipiellen Darstellung.

Der Hochspannungsmessteiler besteht im Wesentlichen aus

-　einem ersten Strang mit ersten Parallelschaltungen 45 aus jeweils einem ohmschen Widerstand R2 bis RN und einem Kondensator C2 bis CN in Reihenschaltung,

-　einem zweiten Strang mit einer zweiter Parallelschaltung 46 aus einem ohmschen Widerstand R1 und wenigstens einem Kondensator C1 in Reihe mit ersten Parallelschaltungen 45 aus jeweils einem ohmschen Widerstand R2 bis RN und einem Kondensator C2 bis CN und

- einem dritten Strang mit ersten Parallelschaltungen 45 aus jeweils einem ohmschen Widerstand R2 bis RN und einem Kondensator C2 bis CN in Reihenschaltung. Die Stränge sind parallel zueinander geschaltet und besitzen Anschlüsse 42, 43. Die Verbindung zwischen den ersten Parallelschaltungen 45 und der zweiten Parallelschaltung 46 des zweiten Stranges sind der Abgriff 44 des Hochspannungsmessteilers 39.

Die Fig. 11 zeigt eine Leiterplatte 40 mit Widerständen R und Kondensatoren C als Spannungsteiler in einer prinzipiellen Draufsicht.

Die Leiterplatte 40 weist eine Mäanderform auf, so dass die ersten aus jeweils einem ohmschen Widerstand R und einem Kondensator C bestehende Parallelschaltungen 45 mäanderförmig verlaufend auf der Leiterplatte 40 angeordnet sind. Die Widerstände R und Kondensatoren C sind mit Leiterbahnen der Leiterplatte zusammengeschaltet. Damit sind die mäanderförmig ausgebildeten plattenförmigen Bauelementeträger bekannte Leiterplatten 40 mit Leiterbahnen und Kontaktstellen. Auf den Leiterplatten 40 befinden sich die Kondensatoren C und die Widerstände R als oberflächenmontierbare Bauelemente, die mittels bekannter Lötverfahren mit Kontaktstellen und/oder Leiterbahnen der Leiterplatte 40 elektrisch leitend verbunden sind.

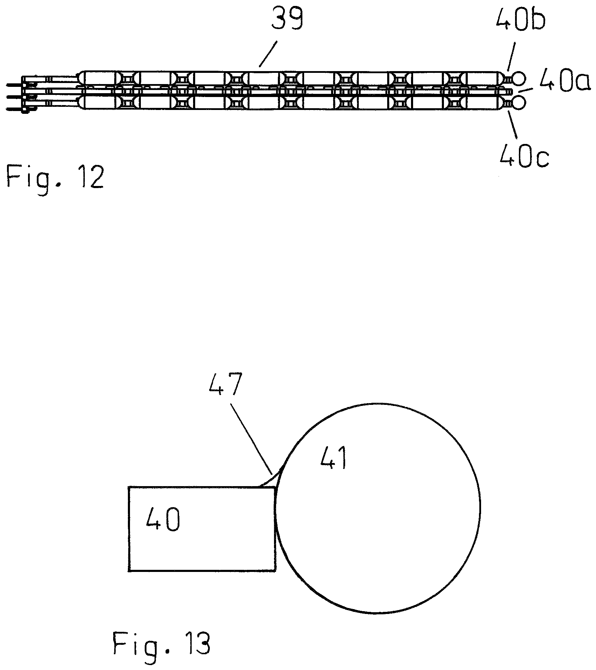

Die Fig. 12 zeigt einen Hochspannungsmessteiler 39 in einer prinzipiellen Seitenansicht.

Drei derartige bestückte Leiterplatten 40a, 40b, 40c sind übereinander angeordnet.

Die Fig. 13 zeigt ein Feldsteuerelement 41 an einer Leiterplatte 40 in einer prinzipiellen Darstellung.

An nach außen weisenden Kanten wenigstens einer der Leiterplatten 40 hier an zwei Leiterplatten 40b, 40c befinden sich die Feldsteuerelemente 41. Diese sind aus einem elektrisch leitfähigen Material bestehende Zylinderstücke mit als Kugelkappen ausgebildeten Endenbereichen, die mittels Löten und damit mittels Lötzinn 47 mit Leiterbahnen der Leiterplatte 40 verbunden sind. Dazu bestehen die Feldsteuerelemente 41 aus einem weichlötbaren Material, beispielsweise Kupfer oder Messing. Das Zylinderstück kann eine Nut zur Aufnahme des Endbereichs der Leiterplatte 40 besitzen.

Die Leiterplatten 40 können sich bis auf die von außen zugänglichen Anschlüsse 42, 43, 44 beabstandet zueinander in einer Vergussmasse befinden. Dazu sind die Leiterplatten 40 mit Schraubverbindungen miteinander verbunden.

Die beiden äußeren Leiterplatten 40b, 40c mit dem ersten und dem dritten Strang sind Feldsteuerbauteile und die mittlere Leiterplatte 40a mit dem zweiten Strang der Messspannungsteiler.

Die Mäanderform gewährleistet einen minimalen Platzbedarf. Natürlich können die Parallelschaltungen 45, 46 auch geradlinig angeordnet sein.

**Bezugszeichen**

| | |
|---|---|
| 1 | Hochspannungsquelle |
| 2 | Stromquelle |
| 3 | Stromquelle |
| 4 | Kabel |
| 5 | Spannungsteiler |
| 6 | Schutzwiderstand |
| 7 | Steuereinrichtung |
| 8 | Koppeldiode |
| 9 | Koppeldiode |
| 10 | Hauptwandler |
| 11 | Hilfswandler |
| 12 | Schalteinrichtung |
| 13 | Kaskade für positive Hochspannung |
| 14 | Kaskade für negative Hochspannung |
| 15 | Trafo des Hilfswandler |
| 16 | Wechselrichter des Hilfswandlers |
| 17 | Spannungsvervielfacher des Hilfswandlers |
| 18 | Gleichrichter |
| 19 | Einrichtung zur Wechselspannungserzeugung |
| 20 | Trafo des Hauptwandlers |
| 21 | Relais |
| 22 | Messimpedanz |
| 23 | Hilfserde |
| 24 | Spannungsteiler |
| 25 | Messwerterfassung |
| 26 | Zwischenkreis |
| 27 | Verbindung |
| 28 | Diode zwischen Hilfswandler und Kaskade |
| 29 | Ansteuerschaltung |
| 30 | optischer Empfänger |
| 31 | Demodulator |
| 32 | Operationsverstärker |
| 33 | Pegelanpasser |
| 34 | Lichtwellenleiter |
| 35 | Potential der Stromquelle |
| 36 | invertierender Verstärker |
| 37 | Bezugspotential der Ansteuerschaltung |
| 38 | Einrichtung zur Überwachung |
| 39 | Hochspannungsmessteiler |
| 40 | Leiterplatte |
| 41 | Feldsteuerelement |
| 42 | Anschluss |
| 43 | Anschluss |
| 44 | Abgriff |
| 45 | erste Parallelschaltung |
| 46 | zweite Parallelschaltung |
| 47 | Lötzinn |
| | |
| i_Gate | Strom durch die Gatewiderstände |
| R | ohmscher Widerstand |
| RG | Gatewiderstand |
| T | spannungsgesteuerter Transistor |
| u_Soll | Sollspannung |
| V | Potential |

V+      Versorgungsspannung der Ansteuerschaltung

ZD      Zenerdiode

C      Kondensator

**Patentansprüche**

1. Schaltungsanordnung zur Kabelprüfung, Kabeltestung, Kabeldiagnose und/oder Kabelfehlerortung in Verbindung mit einem Kabel (4) mit

   - einer einen ersten Spannungsvervielfacher (13) für eine positive Spannung und einen zweiten Spannungsvervielfacher (14) für eine negative Spannung aufweisenden Spannungsquelle (1),
   - einem Schutzwiderstand (6),
   - einem Spannungsteiler (5),
   - miteinander verbundenen Stromquellen (2, 3) in Verbindung mit den Spannungsvervielfachern (13, 14) zum Erzeugen einer Prüfspannung über der Lastimpedanz des Kabels (4) zum Aufladen und zum Entladen der Lastkapazität des Kabels (4), wobei die miteinander verbundenen Stromquellen (2, 3) über den Schutzwiderstand (6) mit dem Kabel (4) und dem Spannungsteiler (5) verbunden sind, und
   - einer mit der Spannungsquelle (1) und den Stromquellen (2, 3) zusammengeschalteten Steuereinrichtung (7), **dadurch gekennzeichnet,**
   **dass** die Steuereinrichtung (7) einen digitalen Signalprozessor zur Regelung der über den Spannungsteiler (5) gemessenen Prüfspannung über der Lastimpedanz des Kabels (4) und zur Sollwertvorgabe der Spannungsquelle (1) aufweist, dass die Spannungsvervielfacher (13, 14) entweder mit zwei Hauptwandlern (10a, 10b) oder sowohl einem Hauptwandler (10) als auch einem eine positive und eine negative Hilfsspannung erzeugenden Hilfswandler (11) so verbunden sind, dass an den Ausgängen der Spannungsvervielfacher (13, 14) entweder eine entsprechend der Sollwertvorgabe positive Spannung und eine konstante ungesteuerte negative Spannung oder eine entsprechend der Sollwertvorgabe negative Spannung und eine konstante ungesteuerte positive Spannung anliegen, wobei die jeweilig ungesteuerte Spannung entweder durch den jeweiligen Hauptwandler (10a, 10b) oder durch den ungesteuerten Hilfswandler (11) erzeugt wird, dass die Spannungsvervielfacher (13, 14) über jeweils eine Koppeldiode (8, 9) mit den Stromquellen (2, 3) zusammengeschaltet sind, so dass das Rückwärtsspeisen der Spannungsvervielfacher (13, 14) verhindert ist, dass die miteinander verbundenen Stromquellen (2, 3) über wenigstens einen Schutzwiderstand (6) mit dem Spannungsteiler (5) und dem Kabel (4) verbunden sind und dass die beiden miteinander verbundenen Bezugspotentiale der Spannungsvervielfacher (13, 14) über eine an den Messbereich anpassbare Messimpedanz (22) mit dem Bezugspotential des Kabels (4) verbunden sind, wobei die Bezugspotentiale der Spannungsvervielfacher (13, 14) und das Bezugspotential des Spannungsteilers (5) eine Hilfserde (23) sind.

2. Schaltungsanordnung nach Patentanspruch 1, **dadurch gekennzeichnet, dass** die Steuereinrichtung (7) über eine Schalteinrichtung (12) mit den Hauptwandlern (10a, 10b) so verbunden ist, dass an dem über den einen Hauptwandler (10a, 10b) mit der Steuereinrichtung (7) verbundenen Spannungsvervielfacher (13, 14) eine entsprechend der Spannung des digitalen Signalprozessors geführte Spannung eines Potentials anliegt und dass der nicht mit der Steuereinrichtung (7) verbundene andere Hauptwandler (10a, 10b) eine ungesteuerte Spannung des anderen Potentials erzeugt, so dass immer eine Spannung über den Stromquellen (2, 3) anliegt.

3. Schaltungsanordnung nach einem der Patentansprüche 1 und 2, **dadurch gekennzeichnet, dass** die Hauptwandler (10a, 10b) so miteinander verbunden sind, dass die Schalter der Hauptwandler (10a, 10b) frequenzsynchron oder frequenzsynchron mit phasenverschobenen Schaltzeitpunkten zum Verringern oder Vermeiden von Schwebungseffekten und elektrische Störbeeinflussungen schalten.

4. Schaltungsanordnung nach Patentanspruch 1, **dadurch gekennzeichnet, dass** der Hilfswandler (11) als eine positive und eine negative Hochspannungsquelle einen primärseitig mit einem Transformator (15) zusammengeschalteten Wechselrichter (16) und sekundärseitig verbundene Spannungsvervielfacher (17) für die positive und die negative ungesteuerte Spannung umfasst.

5. Schaltungsanordnung nach einem der Patentansprüche 1 und 4, **dadurch gekennzeichnet, dass** der Hilfswandler (11) mit den Spannungsvervielfachern (13, 14) und der Hauptwandler (10) über eine Schalteinrichtung (12) mit den Spannungsvervielfachern (13, 14) verbunden sind, und dass der Hauptwandler (10) und die Schalteinrichtung (12) so mit der Steuereinrichtung (7) zusammengeschaltet sind, dass an dem über die Schalteinrichtung (12) mit dem Hauptwandler (10) verbundenem Spannungsvervielfacher (13, 14) die Spannung des Hilfswandlers (11) und die entsprechend der Spannung des digitalen Signalprozessors geführte Spannung des Hauptwandlers jeweils eines Potentials anliegt und dass der andere Spannungsvervielfacher nur mit dem Hilfswandler (11) verbunden ist, so dass an diesem Spannungsvervielfacher eine ungesteuerte Spannung des anderen Potentials anliegt.

6. Schaltungsanordnung nach einem der Patentansprüchen 1, 4 und 5, **dadurch gekennzeichnet, dass** der Hauptwandler (10) so mit der Steuereinrichtung (7) verbunden ist, dass der Hauptwandler (10) während des Spannungsnulldurchgangs der Lastspannung am Kabel (4) von den Spannungsvervielfachern (13, 14) getrennt ist und damit nur noch der Hilfswandler (11) autark die positive und die negative Spannung an den Ausgängen der Spannungsvervielfacher (13, 14) erzeugt und somit nur die Spannung des Hilfswandlers (11) an den Ausgängen der Spannungsvervielfacher (13, 14) anliegt.

7. Schaltungsanordnung nach einem der Patentansprüchen 1 und 4 bis 6, **dadurch gekennzeichnet, dass** der digitale Signalprozessor ein einen digitalen Sinus als Referenzsinus ausgebender digitaler Sinusgenerator ist und dass die Steuereinrichtung (7) eine dem Referenzsinus eine Konstante zuaddierende Steuereinrichtung (7) ist, so dass zum Einen während der positiven Halbschwingung der Lastspannung eine exakte Phasenlage und Offset zwischen der Spannung am Ausgang des positiven Spannungsvervielfachers (13) und der positiven Halbschwingung der Lastspannung vorhanden ist, wobei gleichzeitig durch den Hilfswandler (11) eine nicht synchrone und ungesteuerte negative Gleichspannung zur positiven Halbschwingung an dem negativen Spannungsvervielfacher (14) erzeugt wird, und zum Anderen während der negativen Halbschwingung der Lastspannung eine exakte Phasenlage und Offset zwischen der Spannung am Ausgang des negativen Spannungsvervielfachers (14) und der negativen Halbschwingung der Lastspannung vorhanden ist, wobei gleichzeitig durch den Hilfswandler (11) eine nicht synchrone und ungesteuerte positive Gleichspannung zur negativen Halbschwingung an dem positiven Spannungsvervielfacher (13) erzeugt wird.

8. Schaltungsanordnung nach Patentanspruch 1, **dadurch gekennzeichnet, dass** der digitale Signalprozessor ein einen digitalen Sinus ausgebender digitaler Sinusgenerator ist, dass die Steuereinrichtung (7) eine die Ausgangsspannungen der Spannungsvervielfacher (13, 14) der Spannungsquelle (1) abfragende und eine die neuen Sollwerte aus dem digitalen Sinusgenerator berechnende Steuereinrichtung (7) ist und dass die Steuereinrichtung (7) eine die Spannung über dem Kabel (4) auf den neuen Sollwert aus dem digitalen Sinusgenerator regelnde Steuereinrichtung (7) ist.

9. Schaltungsanordnung nach Patentanspruch 1, **dadurch gekennzeichnet, dass** der Hauptwandler (10, 10a, 10b) ein die Netzspannung wandelnder Hauptwandler (10) ist, wobei dazu ein Gleichrichter (18), eine Einrichtung (19) zur Wechselspannungserzeugung mit einer Vollbrücke oder Halbbrücke und einem Resonanzkreis zur Speisung eines Transformators (20) und der Transformator (20) nacheinander zusammengeschaltet sind.

10. Schaltungsanordnung nach Patentanspruch 1, **dadurch gekennzeichnet, dass** der Spannungsvervielfacher (13, 14) eine Hochspannungskaskade als eine Greinacher-Schaltung oder als eine aus der Greinacher-Schaltung abgeleitete Hochspannungskaskade mit Vollweggleichrichtung ohne Glättungssäule ist.

11. Schaltungsanordnung nach Patentanspruch 1, **dadurch gekennzeichnet, dass** der Schutzwiderstand (6) gleichzeitig ein Entladewiderstand ist.

12. Schaltungsanordnung nach Patentanspruch 1, **dadurch gekennzeichnet, dass** die Stromquelle (2, 3) eine potentialfreie spannungsgesteuerte Stromquelle (2, 3) zur Steuerung der Hochspannungsquelle 1 mit einer Reihenschaltung aus einem Widerstand (R) und in Reihe geschalteten spannungsgesteuerten Transistoren (T1, T2, ... TN) zwischen den Potentialen und einer mit den spannungsgesteuerten Transistoren (T1, T2, ... TN) verbundenen Ansteuerschaltung (29) mit einem optischen Empfänger (30) und einem Operationsverstärker (32) ist, dass zwischen den in Reihe geschalteten spannungsgesteuerten Transistoren (T1, T2, ... TN) und dem Widerstand (R) eine Zenerdiode (ZD), eine Suppressordiode oder ein Linearspannungsregler geschalten ist, dass der freie Anschluss des Widerstandes (R) ein Potential (35) der potentialfreien spannungsgesteuerten Stromquelle ist und dass entweder die über die Zenerdiode (ZD), die Suppressordiode oder den Linearspannungsregler anliegende Spannung oder die über den Widerstand (R) und die Zenerdiode (ZD), die Suppressordiode oder den Linearspannungsregler anliegende Spannung die Versorgungsspannung der Ansteuerschaltung (29) ist.

13. Schaltungsanordnung nach Patentanspruch 1, **dadurch gekennzeichnet, dass** der Spannungsteiler (5) ein Hochspannungsmessteiler (39) ist, dass auf plattenförmigen Bauelementeträgern erste aus jeweils einem ohmschen Widerstand (R) und einem Kondensator (C) bestehende Parallelschaltungen (45) in Reihenschaltung und auf mindestens einem der Bauelementeträger wenigstens eine zweite Parallelschaltung (46) aus einem ohmschen Widerstand (R) und wenigstens einem Kondensator (C) angeordnet sind, dass wenigstens drei Bauelementeträger übereinander angeordnet sind, dass wenigstens ein Bauelementeträger an nach außen weisenden Kanten Feldsteuerelemente (41) aufweist, dass die Feldsteuerelemente (41) aus einem elektrisch leitfähigem Material bestehende Zylinder- oder Rohrstücke mit als Kugelkappen ausgebildeten Endenbereichen sind und dass die äußeren wenigstens die ersten Parallelschaltungen (45) aufweisenden Bauelementeträger Feldsteuerbauteile und der mittlere Bauelementeträger mit den ersten Parallelschaltungen (45) und der zweiten Parallelschaltung (46) der Messspannungsteiler sind, wobei die Verbindung zwischen den ersten Parallelschaltungen (45) und der zweiten Parallelschaltung (46) des Messspannungsteilers der Abgriff (44) des Hochspannungsmessteilers (39) und die ersten Parallelschaltungen (45) der Feldsteuerbauteile und die Reihenschaltung aus ersten Parallelschaltungen (45) und zweiter Parallelschaltung (46) des Messspannungsteilers parallel zueinander geschalten die weiteren Anschlüsse (42, 43) des Hochspannungsmessteilers (39) sind.

14. Gerät zur Kabelprüfung, Kabeltestung, Kabeldiagnose und/oder Kabelfehlerortung mit einer Schaltungsanordnung nach Patentanspruch 1, **dadurch gekennzeichnet, dass** sich die Spannungsquelle (1) in einer abgeschirmten Umhausung befindet, wobei die Umhausung die Hilfserde (23) ist, und dass das Anschlusskabel des Kabels (4) ein abgeschirmtes Anschlusskabel ist, wobei die Abschirmung des Anschlusskabels mit der Hilfserde (23) verbunden ist, oder dass das Anschlusskabel des Kabels (4) ein abgeschirmtes Anschlusskabel mit zwei separaten Schirmen ist, wobei der innere Schirm die Hilfserde (23) ist und der äußere Schirm mit der Erdpotential verbunden ist.

15. Gerät nach Patentanspruch 14, **dadurch gekennzeichnet, dass** die Umhausung, die Stromquellen (2, 3), die Steuereinrichtung (7), die Koppeldioden (8, 9), der Schutzwiderstand (6) und der Spannungsteiler (5) in einem mit Erdpotential verbundenem oder verbindbarem Gehäuse angeordnet sind, so dass das Gerät ein mobiles Gerät ist oder sich das Gerät in einem Fahrzeug befindet.

**Claims**

1. Circuit assembly for cable checking, cable testing, cable diagnosis and/or cable fault localisation in conjunction with a cable (4), comprising

   - a voltage source (1) having a first voltage multiplier (13) for a positive voltage and a second voltage multiplier (14) for a negative voltage,
   - a protective resistor (6),
   - a voltage divider (5),
   - interconnected current sources (2, 3) in conjunction with the voltage multipliers (13, 14) for generating a test voltage across the load impedance of the cable (4) in order to charge and discharge the load capacity of the cable (4), the interconnected current sources (2, 3) being connected to the cable (4) and to the voltage divider (5) via the protective resistor (6), and
   - a controller (7) coupled to the voltage source (1) and to the current sources (2, 3), **characterised in that**

   the controller (7) has a digital signal processor for controlling the test voltage across the load impedance of the cable (4), which voltage is measured across the voltage divider (5), and for specifying the target value of the voltage source (1), **in that** the voltage multipliers (13, 14) are connected either to two main converters (10a, 10b) or to a main converter (10) and an auxiliary converter (11) that generates a positive and a negative auxiliary voltage, such that either a positive voltage corresponding to the target value specification and a constant, uncontrolled negative voltage or a negative voltage corresponding to the target value specification and a constant, uncontrolled positive voltage are applied to the outputs of the voltage multipliers (13, 14), the particular uncontrolled voltage being generated either by the respective main converters (10a, 10b) or by the uncontrolled auxiliary converter (11), **in that** the voltage multipliers (13, 14) are coupled to the current sources (2, 3) via a coupling diode (8, 9) in each case, such that rearward powering of the voltage multipliers (13, 14) is prevented, **in that** the interconnected current sources (2, 3) are connected to the voltage divider (5) and to the cable (4) via at least one protective resistor (6), and **in that** the two interconnected reference potentials of the voltage multipliers (13, 14) are connected to the reference potential of the cable (4) via a measurement impedance (22) that can be adapted to the measurement region, the reference potentials of the voltage multipliers (13, 14) and the reference potential of the voltage divider (5) being an auxiliary earth (23).

2. Circuit assembly according to claim 1, **characterised in that** the controller (7) is connected to the main converters (10a, 10b) via a switching device (12) such that a voltage of a potential that is guided corresponding to the voltage of the digital signal processor is applied to the voltage multipliers (13, 14) connected to the controller (7) via the one main converter (10a, 10b), and **in that** the other main converter (10a, 10b) not connected to the controller (7) generates an uncontrolled voltage of the other potential, such that a voltage is always applied across the current sources (2, 3).

3. Circuit assembly according to claim 1 or claim 2, **characterised in that** the main converters (10a, 10b) are interconnected such that the switches of the main converters (10a, 10b) switch in synchronised frequencies or in synchronised frequencies at phase-shifted switching times in order to reduce or avoid beat effects and electrical interference.

4. Circuit arrangement according to claim 1, **characterised in that** the auxiliary converter (11) comprises, as a positive and a negative high voltage source, an inverter (16) coupled to a transformer (15) on the primary side and voltage multipliers (17) connected on the secondary side for the positive and the negative uncontrolled voltage.

5. Circuit arrangement according to claim 1 or 4, **characterised in that** the auxiliary converter (11) is connected to the voltage multipliers (13, 14) and the main converter (10) is connected to the voltage multipliers (13, 14) via a switching device (12), and **in that** the main converter (10) and the switching device (12) are coupled to the controller (7), such that the voltage of the auxiliary converter (11) and the voltage of the main converter of a potential in each case, which voltage is guided corresponding to the voltage of the digital signal processor, are applied to the voltage multiplier (13, 14) connected to the main converter (10) via the switching device (12), and **in that** the other voltage multiplier is only connected to the auxiliary multiplier (11), such that an uncontrolled voltage of the other potential is applied to said voltage multiplier.

6. Circuit arrangement according to any of claims 1, 4 and 5, **characterised in that** the main converter (10) is connected to the controller (7) such that the main converter (10) is separated from the voltage multipliers (13, 14) during the voltage zero crossing of the load voltage at the cable (4) and thereby only the auxiliary converter (11) still independently generates the positive and the negative voltage at the outputs of the voltage multipliers (13, 14) and thus only the voltage of the auxiliary converter (11) is applied to the outputs of the voltage multipliers (13, 14).

7. Circuit arrangement according to any of claims 1 and 4 to 6, **characterised in that** the digital signal processor is a digital sine generator that outputs a digital sine as a reference sine, and **in that** the controller (7) is a controller (7) that adds a constant to the reference sine, such that, during the positive semioscillation of the load voltage, an exact phase position and offset between the voltage at the output of the positive voltage multiplier (13) and the positive semioscillation of the load voltage is present, an asynchronous and uncontrolled negative DC voltage being simultaneously generated by the auxiliary converter (11) for the positive semioscillation at the negative voltage multiplier (14), and, during the negative semioscillation of the load voltage, an exact phase position and offset between the voltage at the output of the negative voltage multiplier (14) and the negative semioscillation of the load voltage is present, an asynchronous and uncontrolled positive DC voltage being simultaneously generated by the auxiliary converter (11) for the negative semioscillation at the positive voltage multiplier (13).

8. Circuit arrangement according to claim 1, **characterised in that** the digital signal processor is a sine generator that outputs a digital sine, **in that** the controller (7) is a controller (7) that queries the output voltages of the voltage multipliers (13, 14) of the voltage source (1) and calculates the new target value from the digital sine generator, and **in that** the controller (7) is a controller (7) that controls the voltage across the cable (4) to the new target value from the digital sine generator.

9. Circuit arrangement according to claim 1, **characterised in that** the main converter (10, 10a, 10b) is a main converter (10) that transforms the mains voltage, a rectifier (18), a device (19) for generating an AC voltage having a full bridge or a half bridge and a resonant circuit for powering a transformer (20), and the transformer (20) being coupled in succession to one another.

10. Circuit arrangement according to claim 1, **characterised in that** the voltage multiplier (13, 14) is a high voltage cascade as a Greinacher circuit or as a high voltage cascade derived from the Greinacher circuit having full-wave rectification without a smoothing column.

11. Circuit arrangement according to claim 1, **characterised in that** the protective resistor (6) is simultaneously a discharging resistor.

12. Circuit arrangement according to claim 1, **characterised in that** the current source (2, 3) is a potential-free, voltage-controlled current source (2, 3) for controlling the high voltage source (1) having a series circuit made of a resistor (R) and voltage-controlled transistors (T1, T2, ... TN) connected in series between the potentials and a control circuit (29) connected to the voltage-controlled transistors (T1, T2, ... TN) having an optical receiver (30) and an operational amplifier (32), **in that**, between the voltage-controlled transistors (T1, T2, ... TN) connected in series and the resistor (R), a Zener diode (ZD), a suppressor diode or a linear voltage controller is connected, **in that** the free terminal of the resistor (R) is a potential (35) of the potential-free, voltage-controlled current source, and **in that** either the voltage applied across the Zener diode (ZD), the suppressor diode or the linear voltage controller or the voltage applied across the resistor (R) and the Zener diode (ZD), the suppressor diode or the linear voltage controller is the supply voltage of the control circuit (29).

13. Circuit arrangement according to claim 1, **characterised in that** the voltage divider (5) is a high voltage measurement divider (39), **in that**, on planar component carriers, first parallel circuits (45) consisting in each case of an ohmic resistor (R) and a capacitor (C) are connected in series and on at least one of the component carriers at least one second parallel circuit (46) consisting of an ohmic resistor (R) and at least one capacitor (C) are arranged, **in that** at least three component carriers are arranged one above the other, **in that** at least one component carrier has field control elements (41) on outwardly facing edges, **in that** the field control elements (41) are cylindrical or tubular parts consisting of an electrically conductive material and having end regions formed as spherical caps, and **in that** the outer component carriers which have at least the first parallel circuits (45) are field control components and the central component carrier having the first parallel circuits (45) and the second parallel circuit (46) is the measurement voltage divider, the connection between the first parallel circuits (45) and the second parallel circuit (46) of the measurement voltage divider being the tap (44) of the high voltage measurement divider (39) and the first parallel circuits (45) of the field control components and the series circuit consisting of first parallel circuits (45) and the second parallel circuit (46) of the measurement voltage divider, connected in parallel with one another, are the further terminals (42, 43) of the high voltage measurement divider (39).

14. Instrument for cable checking, cable testing, cable diagnosis and/or cable fault localisation, having a circuit arrangement according to claim 1, **characterised in that** the voltage source (1) is located in a shielded enclosure, the enclosure being the auxiliary earth (23), and **in that** the connection cable of the cable (4) is a shielded connection cable, the shield of the connection cable being connected to the auxiliary earth (23), or **in that** the connection cable of the cable (4) is a shielded connection cable having two separate shields, the inner shield being the auxiliary earth (23) and the outer shield being connected to the earth potential.

15. Instrument according to claim 14, **characterised in that** the enclosure, the current sources (2, 3), the controller (7), the coupling diodes (8, 9), the protective resistor (6) and the voltage divider (5) are arranged in a housing that is or can be connected to the earth potential, such that the instrument is a mobile instrument or the instrument is located in a vehicle.

**Revendications**

1. Ensemble circuit en liaison avec un câble (4), servant à contrôler, à tester, à diagnostiquer des câbles et/ou à localiser des défauts de câble, avec

   - une source de tension (1) présentant un premier multiplicateur de tension (13) pour une tension positive et un second multiplicateur de tension (14) pour une tension négative,
   - une résistance de protection (6),
   - un diviseur de tension (5),
   - des sources de courant interconnectées (2, 3) en liaison avec les multiplicateurs de tension (13, 14) pour générer une tension d'essai aux bornes de l'impédance de charge du câble (4) pour charger et décharger la capacitance de charge du câble (4), dans lequel les sources de courant interconnectées (2, 3) sont reliées au câble (4) et au diviseur de tension (5) par l'intermédiaire de la résistance de protection (6), et
   - un dispositif de commande (7) connecté à la source de tension (1) et aux sources de courant (2, 3), **caractérisé en ce que** le dispositif de commande (7) présente un processeur de signal numérique permettant de réguler la tension d'essai aux bornes de l'impédance de charge du câble (4) mesurée aux bornes du diviseur de tension (5) et permettant de spécifier la valeur de consigne de la source de tension (1), **en ce que** les multiplicateurs de tension (13, 14) sont reliés soit à deux convertisseurs principaux (10a, 10b) soit à la fois à un convertisseur principal (10) et à un convertisseur auxiliaire (11) générant une tension auxiliaire positive et négative de telle sorte qu'aux sorties des multiplicateurs de tension (13, 14), il y ait soit une tension positive selon la spécification de la valeur de consigne et une tension négative non commandée constante, soit une tension négative selon la spécification de la valeur de consigne et une tension positive non commandée constante, dans lequel la tension non commandée respective est générée soit par le convertisseur principal respectif (10a, 10b) ou par le convertisseur auxiliaire (11) non commandé, **en ce que** les multiplicateurs de tension (13, 14) sont connectés aux sources de courant (2, 3) par l'intermédiaire d'une diode de couplage (8, 9) de manière à empêcher l'alimentation en retour des multiplicateurs de tension (13, 14), **en ce que** les sources de courant interconnectées (2, 3) sont reliées au diviseur de tension (5) et au câble (4) par l'intermédiaire d'au moins une résistance de protection (6), et **en ce que** les deux potentiels de référence interconnectés des multiplicateurs de tension (13, 14) sont reliés au potentiel de référence du câble (4) par l'intermédiaire d'une l'impédance de mesure (22) adaptable à la plage de mesure, dans lequel les potentiels de référence des multiplicateurs de tension (13, 14) et le potentiel de référence du diviseur de tension (5) sont une terre auxiliaire (23).

2. Ensemble circuit selon la revendication 1, **caractérisé en ce que** le dispositif de commande (7) est relié aux convertisseurs principaux (10a, 10b) par l'intermédiaire d'un dispositif de commutation (12) de telle sorte qu'une tension d'un potentiel qui correspond à la tension du processeur de signal numérique soit appliquée au multiplicateur de tension (13, 14) relié au dispositif de commande (7) par l'intermédiaire de l'un des convertisseurs principaux (10a, 10b), et **en ce que** l'autre convertisseur principal (10a, 10b) non connecté au dispositif de commande (7) génère une tension non commandée de l'autre potentiel de telle sorte qu'une tension s'applique toujours aux bornes des sources de courant (2, 3).

3. Ensemble circuit selon l'une des revendications 1 et 2, **caractérisé en ce que** les convertisseurs principaux (10a, 10b) sont interconnectés de telle sorte que les commutateurs des convertisseurs principaux (10a, 10b) sont en synchronisation de fréquence ou en synchronisation de fréquence avec des moments de commutation décalés en phase, de façon à réduire ou éviter les effets de battement et à commuter les interférences électriques.

4. Ensemble circuit selon la revendication 1, **caractérisé en ce que** le convertisseur auxiliaire (11) comprend, comme une source haute tension positive et négative, un inverseur (16) connecté côté primaire à un transformateur (15) et un multiplicateur de tension (17) connecté côté secondaire pour la tension positive et négative non commandée.

5. Ensemble circuit selon l'une des revendications 1 et 4, **caractérisé en ce que** le convertisseur auxiliaire (11) est relié aux multiplicateurs de tension (13, 14), et le convertisseur principal (10) est relié aux multiplicateurs de tension (13, 14) par l'intermédiaire d'un dispositif de commutation (12), et **en ce que** le convertisseur principal (10) et le dispositif de commutation (12) sont connectés au dispositif de commande (7) de telle sorte que la tension du convertisseur auxiliaire (11) et la tension du convertisseur principal d'un potentiel correspondant à la tension du processeur de signal numérique soient appliquées au multiplicateur de tension (13, 14) relié au convertisseur principal (10) par l'intermédiaire du dispositif de commutation (12), et **en ce que** l'autre multiplicateur de tension est relié uniquement au convertisseur auxiliaire (11) de telle sorte qu'une tension non commandée de l'autre potentiel soit appliquée audit multiplicateur de tension.

6. Ensemble circuit selon l'une des revendications 1, 4 et 5, **caractérisé en ce que** le convertisseur principal (10) est connecté au dispositif de commande (7) de telle sorte que le convertisseur principal (10) soit séparé des multiplicateurs de tension (13, 14) lors du passage de tension par zéro de la tension de charge au niveau du câble (4), et ainsi, seul le convertisseur auxiliaire (11) génère de manière autonome la tension positive et négative aux sorties des multiplicateurs de tension (13, 14) et par conséquent seule la tension du convertisseur auxiliaire (11) s'applique aux sorties des multiplicateurs de tension (13, 14).

7. Ensemble circuit selon l'une des revendications 1 et 4 à 6, **caractérisé en ce que** le processeur de signal numérique est un générateur de sinus numérique qui délivre un sinus numérique comme sinus de référence, et **en ce que** le dispositif de commande (7) est un dispositif de commande (7) qui ajoute une constante au sinus de référence de telle sorte que, d'une part, il existe une position de phase exacte et un décalage entre la tension à la sortie du multiplicateur de tension positive (13) et la demi-période positive de la tension de charge pendant la demi-période positive de la tension de charge, dans lequel une tension continue négative non synchrone et non commandée est générée simultanément par le convertisseur auxiliaire (11) pour produire la demi-période positive au niveau du multiplicateur de tension négative (14), et d'autre part, il existe une position de phase exacte et un décalage entre la tension à la sortie du multiplicateur de tension négative (14) et la demi-période négative de la tension de charge pendant la demi-période positive de la tension de charge, dans lequel une tension continue positive non synchrone et non commandée est générée simultanément par le convertisseur auxiliaire (11) pour produire la demi-période négative au niveau du multiplicateur de tension positive (13).

8. Ensemble circuit selon la revendication 1, **caractérisé en ce que** le processeur de signal numérique est un générateur de sinus numérique qui délivre un sinus numérique, **en ce que** le dispositif de commande (7) est un dispositif de commande (7) qui interroge les tensions de sortie des multiplicateurs de tension (13, 14) de la source de tension (1) et qui calcule les nouvelles valeurs de consigne à partir du générateur de sinus numérique, et **en ce que** le dispositif de commande (7) est un dispositif de commande (7) qui règle la tension aux bornes du câble (4) sur la nouvelle valeur de consigne du générateur de sinus numérique.

9. Ensemble circuit selon la revendication 1, **caractérisé en ce que** le convertisseur principal (10, 10a, 10b) est un convertisseur principal (10) convertissant la tension de secteur, dans lequel, à cet effet, un redresseur (18), un dispositif (19) permettant de générer une tension alternative avec un pont intégral ou un demi-pont et un circuit de résonance permettant d'alimenter un transformateur (20), et le transformateur (20) sont connectés en série.

10. Ensemble circuit selon la revendication 1, **caractérisé en ce que** le multiplicateur de tension (13, 14) est une cascade haute tension en tant que circuit de Greinacher ou en tant que cascade haute tension dérivée du circuit de Greinacher avec redressement à deux alternances sans colonne de lissage.

11. Ensemble circuit selon la revendication 1, **caractérisé en ce que** la résistance de protection (6) est à la fois une résistance de décharge.

12. Ensemble circuit selon la revendication 1, **caractérisé en ce que** la source de courant (2, 3) est une source de courant (2, 3) commandée en tension sans potentiel permettant de commander la source haute tension 1 par un couplage en série comprenant une résistance (R) et des transistors (T1, T2, ... TN) commandés en tension et connectés en série entre les potentiels, et un circuit de commande (29) relié aux transistors (T1, T2, ... TN) commandés en tension, ledit circuit de commande comportant un récepteur optique (30) et un amplificateur opérationnel (32), **en ce qu'**une diode Zener (ZD), une diode-suppresseur ou un régulateur de tension linéaire est connecté(e) entre les transistors (T1, T2, ... TN) commandés en tension et connectés en série et la résistance (R), **en ce que** la borne libre de la résistance (R) est un potentiel (35) de la source de courant commandée en tension sans potentiel, et **en ce que** soit la tension appliquée à la diode Zener (ZD), la diode-suppresseur ou le régulateur de tension linéaire, soit la tension appliquée à la résistance (R) et la diode Zener (ZD), la diode-suppresseur ou le régulateur de tension linéaire, est la tension d'alimentation du circuit de commande (29).

13. Ensemble circuit selon la revendication 1, **caractérisé en ce que** le diviseur de tension (5) est un diviseur de mesure haute tension (39), **en ce que**, sur des supports de composants en forme de plaque, des premiers circuits parallèles (45) existants constitués respectivement d'une résistance ohmique (R) et d'un condensateur (C) sont disposés en série, et au moins un second circuit parallèle (46) constitué d'une résistance ohmique (R) et d'au moins un condensateur (C) est disposé sur au moins l'un des supports de composants, **en ce qu'**au moins trois supports de composants sont disposés les uns au-dessus des autres, **en ce qu'**au moins un support de composants présente des éléments de commande de champ (41) au niveau d'arêtes tournées vers l'extérieur, **en ce que** les éléments de commande de champ (41) sont des pièces cylindriques ou tubulaires constituées d'un matériau électriquement conducteur, lesquelles pièces présentent des régions d'extrémité conçues sous forme de calottes sphériques, et **en ce que** les supports de composants externes présentant au moins les premiers circuits parallèles (45) sont des composants de commande de champ et le support de composants central présentant les premiers circuits parallèles (45) et le second circuit parallèle (46) du diviseur de tension de mesure, dans lequel la liaison entre les premiers circuits parallèles (45) et le second circuit parallèle (46) du diviseur de mesure haute tension (39), et les premiers circuits parallèles (45) des composants de commande de champ et le circuit série constitué des premiers circuits parallèles (45) et du second circuit parallèle (46) du diviseur de tension de mesure connectés en parallèle l'un à l'autre sont les bornes (42, 43) supplémentaires du diviseur de mesure haute tension (39).

14. Dispositif servant à contrôler, à tester, à diagnostiquer des câbles et/ou à localiser des défauts de câble au moyen d'un ensemble circuit selon la revendication 1, **caractérisé en ce que** la source de tension (1) est logée dans une enceinte blindée, dans lequel l'enceinte est la terre auxiliaire (23), et **en ce que** le câble de raccordement du câble (4) est un câble de raccordement blindé, dans lequel le blindage du câble de raccordement est relié à la terre auxiliaire (23), ou **en ce que** le câble de raccordement du câble (4) est un câble de raccordement blindé à deux blindages séparés, dans lequel le blindage interne est la terre auxiliaire (23) et le blindage extérieur est relié au potentiel de terre.

15. Dispositif selon la revendication 14, **caractérisé en ce que** l'enceinte, les sources de courant (2, 3), le dispositif de commande (7), les diodes de couplage (8, 9), la résistance de protection (6) et le diviseur de tension (5) sont disposés dans un boîtier relié ou pouvant être relié au potentiel de terre, de sorte que le dispositif soit un dispositif mobile ou que le dispositif se trouve dans un véhicule.

Fig. 1

EP 3 076 195 B1

Fig. 2

EP 3 076 195 B1

Fig. 3

Fig. 4

Fig. 5

Fig. 6

Fig.7

Fig. 8

Fig. 9

39  42        42          42

RN//CN        RN//CN      RN//CN

R2//C2        R2//C2      R2//C2

                    o 44

R1//C1        R1//C1      R1//C1

43            43          43

Fig. 10

42
44

46

45 →

39   41   40

R  C   43

Fig. 11

39    40b

40a

40c

Fig. 12

47

41

40

Fig. 13

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19513441 A1
- DE 102012024560 B3
- DE 102013008611 A1

**In der Beschreibung aufgeführte Nicht-Patentliteratur**

- **KEARLEY, S.J. ; MACKINLAY, R. R.** Discharge measurements in cables using a solid state 30 kV bipolar low frequency generator. *Dielectric Materials, Measurements and Applications, 1988., Fifth International Conference on,* 1988, 171-174